# EUROPÄISCHE PATENTSCHRIFT

(11) **EP 4 402 092 B1**
(45) Veröffentlichungstag und Bekanntmachung des Hinweises auf die Patenterteilung: **30.10.2024**
(21) Anmeldenummer: 23787113.2
(22) Anmeldetag: 10.10.2023
(51) Int. Cl.: B81C 1/00

(54) **MONOLITHISCHE MEMBRAN AUS GLAS, DOPPEL-VERTIKALMEMBRAN-ANORDNUNG, MIKROMECHANISCHE FEDERSTRUKTUR UND ZUGEHÖRIGES HERSTELLUNGSVERFAHREN**
MONOLITHIC GLASS MEMBRANE, DOUBLE VERTICAL MEMBRANE ARRANGEMENT, MICROMECHANICAL SPRING STRUCTURE AND ASSOCIATED PRODUCTION METHOD
MEMBRANE DE VERRE MONOLITHIQUE, AGENCEMENT DE MEMBRANE VERTICALE DOUBLE, STRUCTURE DE RESSORT MICROMÉCANIQUE ET PROCÉDÉ DE PRODUCTION ASSOCIÉ

(30) Priorität: 23.11.2022 DE 102022130976
(43) Veröffentlichungstag der Anmeldung: 24.07.2024
(73) Patentinhaber: LPKF Laser & Electronics SE, 30827 Garbsen (DE)
(72) Erfinder: OSTHOLT, Roman, 30855 Langenhagen (DE); AMBROSIUS, Norbert, 30827 Garbsen (DE); BERTKE, Maik, 30161 Hannover (DE); SCHNEIDER, Sergej, 30171 Hannover (DE); SCHUDAK, Svenja, 30449 Hannover (DE); DUNKER, Daniel, 30419 Hannover (DE)
(74) Vertreter: Mertzlufft-Paufler, Cornelius
(86) Internationale Anmeldenummer: PCT/EP2023/078103
(87) Internationale Veröffentlichungsnummer: WO 2024/110112

(56) Entgegenhaltungen:
- EP-A1- 3 936 485
- WO-A1-2020/030222
- DE-A1- 102018 100 299

## Beschreibung

Die Erfindung betrifft eine monolithische Membran aus Glas. Eine solche Glas-Membran kann zum Beispiel als eine einseitig oder beidseitig aufgehängte Vertikalmembran ausgestaltet sein; oder als eine einseitig oder beidseitig aufgehängte mikromechanischen Biegestruktur oder beispielsweise als ein einseitig oder beidseitig aufgehängter auslenkbarer Federbalken eingesetzt werden. Neben diesen mikromechanischen Anwendungen lässt sich eine solche monolithische Vertikalmembran aus Glas aber auch für andere Anwendungen nutzen, etwa zum Aufbau eines Sensors oder Aktors oder für mikrofluidische Anwendungen.

Die Erfindung betrifft ferner eine Doppel-Vertikalmembran-Anordnung mit wenigstens zwei sich gegenüberliegenden Vertikalmembranen sowie eine hierauf basierende mäandrierende mikromechanische Federstruktur aus Glas.

Die Erfindung betrifft auch eine Verwendung eine spezifische Verwendung einer wie zuvor beschriebenen monolithischen Membran aus Glas. Schließlich betrifft die Erfindung noch ein Verfahren zum Herstellen einer solchen monolithischen Membran aus einem Glassubstrat.

Die reproduzierbare Herstellung von sehr dünnen (< 5um) Membranen oder Biegeelementen ist mit herkömmlichen Methoden eine große Herausforderung und mit viel prozesstechnischem Aufwand verbunden. Mikromechanische Glas-Membranen wie eingangs beschrieben können in vielen Anwendungen, wie etwa der Herstellung von elektronischen Bauteilen (z.B. leistungsfähige Kapazitäten), in der Sensorik (chemisch, biologisch oder mikromechanisch) oder zum Beispiel auch in der Mikrofluidik zum Einsatz kommen.

Darüber hinaus sind gerade vertikal ausgerichtete Biegestrukturen oftmals eine robuste und platzsparende Alternative zu horizontal in der Substratebene auslenkbaren Strukturen in mikromechanischen Anwendungen. Gerade die Herstellung vertikaler Biegestrukturen ist jedoch oftmals mit planaren Technologien (z.B. mittels klassischer Photolithographie) herausfordernd.

Im Stand der Technik werden bereits gewellte Membranen, also Membranen mit variabler Dicke, in vielen Produkten (insbesondere in Lautsprechern) zur Steigerung der mechanischen Flexibilität eingesetzt.

Dünne Membranen oder Feder-/Biegeelemente gehören zudem zu den wichtigsten "building blocks" der Mikrosystemtechnik. Im Bereich MEMS (microelectromechanical systems) gibt es beispielsweise eine Reihe von Ansätzen zur Versteifung von Membranen, meist durch abgeschiedene Materialien, wodurch die Biegeeigenschaften gezielt eingestellt werden können.

Die Veröffentlichung DE 10 2018 100299 A1 beschreibt einen Ansatz zur Strukturierung von dünnen Stegen in Glas durch Ausbildung von Durchgangslöchern, die mittels eines laserbasierten Verfahrens zum Strukturieren von Glas hergestellt werden. Hierbei sind die Stege einseitig monolithisch mit dem Glassubstrat verbunden und könnten daher in der Substratebene ausgelenkt werden.

EP 3 936 485 A1 beschreibt einen Ansatz zum Laserstrukturieren von Glas, bei dem zahlreiche Durchgangslöcher ausgebildet werden, um die Flexibilität des Glassubstrats lokal gezielt zu erhöhen und gleichzeitig eine ausreichende Festigkeit zu gewährleisten.

WO 2020/030222 A1 beschäftigt sich mit dem rückseitigen Freistellen einer Membranschicht, die auf einem Glassubstrat abgeschieden wurde. Hierzu wird vorgeschlagen, entlang einer Umfangskontur rückseitig Modifikationen in das Glassubstrat mit Hilfe eines Lasers einzubringen, um anschließend Glasmaterial innerhalb der Umfangskontur nasschemisch vom Substrat abzutrennen und damit die Membran freizustellen.

Vor diesem technischen Hintergrund hat es sich die Erfindung zur Aufgabe gemacht, eine verbesserte Herstellbarkeit von mikromechanischen Membranen aus Glas zu ermöglichen. Zudem sollen neue Anwendungsmöglichkeiten für Membrane aus Glas mit der Erfindung erschlossen werden.

Zur Lösung dieser Aufgabe sind erfindungsgemäß bei einer monolithischen Membran aus Glas die Merkmale von Anspruch 1 vorgesehen. Insbesondere wird somit erfindungsgemäß zur Lösung der Aufgabe bei einer monolithischen Membran der eingangs genannten Art vorgeschlagen, dass die Membran aus einem Glassubstrat durch laserinduzierte Modifikation des Glassubstrats und nachfolgende nass-chemische Ätzung freigelegt wurde und dass die Membran als eine Vertikalmembran ausgestaltet ist, sodass eine Ebene der Vertikalmembran quer, also insbesondere schräg, zu einer Substratebene des Glassubstrats verläuft. Dabei ist ferner vorgesehen, dass wenigstens eine Oberfläche der Vertikalmembran durch ein Blindloch begrenzt ist, welches mittels laserinduzierter Modifikation des Glassubstrats und nachfolgender nasschemischer Ätzung erzeugt wurde.

Mit anderen Worten schlägt die Erfindung somit vor, die Vertikalmembran mit Hilfe des sogenannten LIDE(laser induced deep etching)-Verfahrens monolithisch in dem Glassubstrat auszubilden. Wenn eine horizontale Richtung dabei in einer Substratebene des Glassubstrats (dies kann beim einem typischen Glas-Wafer beispielsweise dessen Oberfläche sein) verläuft, vor verläuft dabei die Vertikalmembran in einer vertikalen Richtung, also insbesondere schräg zu der Substratebene. Somit verläuft die Vertikalmembran (mehr oder weniger tief) in die Tiefe des Glassubstrats hinein.

Mittels des LIDE-Verfahrens lassen sich auch horizontale Membranen, also Membrane deren Membranebene mit der Substratebene zusammenfällt und deren Hauptauslenkungsrichtung senkrecht zur Substratebene verläuft, vergleichsweise einfach fertigen; solche Membranen besitzen aber oftmals eine relativ hohe Inhomogenität in Bezug auf ihre mechanischen Eigenschaften und sind daher schwierig zu kontrollieren in Bezug auf die Reproduzierbarkeit der Membranschwingung bzw. Membranauslenkung. Zudem benötigen horizontale Membranen oftmals eine große Substratfläche, was sich negativ auswirkt auf den "footprint" des so hergestellten Mikrosystems. Ein weiteres Problem besteht darin, dass horizontale Membranen typischerweise auf bzw. in der Substratoberfläche liegen und daher anfällig gegenüber äußeren mechanischen Einflüssen sind.

Mit dem erfindungsgemäßen Ansatz lassen sich vertikale Membranen mit einer Dicke (in der Substratebene) von weniger als Spm und einer Dickentoleranz von weniger als 1 µm reproduzierbar herstellen, und zwar für unterschiedliche Dicken des verwendeten Glassubstrats (etwa zw. 50 µm und 1000 pm). Dadurch können auch reproduzierbar die mechanischen Eigenschaften der Vertikalmembran eingestellt werden, sodass diese insbesondere als mikromechanisches Biegeelement verwendet werden kann. Mittels erfindungsgemäßer Vertikalmembrane realisierte Biegestrukturen zeigen zudem eine sehr hohe Flexibilität und Bruchfestigkeit und können daher große Auslenkungen verkraften. Zudem werden einige der oben genannten Nachteile von horizontalen Membranen vermieden.

Es versteht sich, dass die hier vorgestellten Vertikalmembrane gerade für mikromechanische Anwendungen von großem Interesse sind und daher mit mikroskopischen Abmessungen ausgestaltet sein können. Die Dicke des Glas-Substrats kann dabei zum Beispiel zwischen 50 µm und mehr als 1 mm betragen. Hierbei kann unter Umständen eine Dimension der Vertikalmembran quer zu Ihrer Längsachse auch mehrere mm oder gar mehr als 1 cm oder sogar mehrere cm betragen.

Das LIDE-Verfahren gehört zum Stand der Technik und ist beispielsweise aus der Patentschrift EP 2964417 B1 vorbekannt. Bislang wurde es häufig eingesetzt, um Strukturen in Glassubstrate zu ätzen, die beispielsweise ein Gehäuse eines Sensors ausbilden. Die Erfindung beschäftigt sich also auch damit, wie die Anwendungen des LIDE-Verfahrens ausgedehnt werden können.

Beim LIDE-Verfahren wird mithilfe eines einzelnen Laserpulses, typischerweise über eine gesamte Dicke eines Glassubstrats hinweg, eine Materialänderung (Modifikation) in den Glaskörper eingebracht, die dazu führt, dass in einem nachfolgenden nass-chemischen Ätzschritt, die so optisch mit dem Laser vorbehandelte/belichtete Struktur im Glassubstrat anisotrop geätzt werden kann, obwohl die Ätzlösung eigentlich isotrope Ätzeigenschaften im Glassubstrat zeigt. Mit dieser Technologie können beispielsweise durchgehende Vias von hoher Qualität in Glas erzeugt werden, was für hermetische Aufbau- und Verbindungstechnik (AVT, bzw. hermetic packaging) von Interesse ist.

Beim LIDE-Verfahren werden ferner gepulste Laser eingesetzt, wobei mit jedem Laserschuss (ein Laserpuls) das Glas entlang der z-Richtung (= optische Achse/Flächennormale des Glassubstrats) modifiziert wird. Hierbei wird typischerweise keinerlei Änderung des verwendeten Strahlprofils angewandt. Beim LIDE-Verfahren werden somit insbesondere keine einzelnen kleinen Volumina (Voxel) innerhalb des Glasvolumens mit dem Laser unterschiedlich bearbeitet, wie bei anderen laserbasierten (z.B. ablativen) Glasbearbeitungsverfahren.

Erfindungsgemäß kann die Aufgabe auch durch weitere vorteilhafte Ausführungen gemäß den Unteransprüchen gelöst werden.

Wie bereits erwähnt ist wenigstens eine Oberfläche der Vertikalmembran (wobei diese Oberfläche insbesondere quer zu einer Hauptauslenkungsrichtung der Vertikalmembran verlaufen kann) durch ein Blindloch begrenzt, welches mittels laserinduzierter Modifikation des Glassubstrats und nachfolgender nasschemischer Ätzung erzeugt wurde. Hierbei kann das Blindloch bevorzugt einen nicht-kreisrunden Querschnitt aufweisen. Es kann also beispielsweise vorgesehen sein, dass das Blindloch quer zu der Hauptauslenkungsrichtung der Vertikalmembran länger ausgestaltet ist als das Blindloch in Richtung einer Flächennormalen des Glassubstrats tief ist.

Eine erfindungsgemäße Vertikalmembran kann bevorzugt durch zwei lateral zueinander versetzte, insbesondere gegenläufige, Blindlöcher begrenzt sein. Hierbei können die beiden Blindlöcher jeweils einen monolithischen Lochboden ausbilden, der mit der Vertikalmembran, also insbesondere mit einem oberen und unteren Ende der Vertikalmembran, verbunden ist. Diese sowie alle im Folgenden beschriebenen Blindlöcher können dabei im selben nasschemischen Schritt wie die Vertikalmembran, also mit Hilfe des LIDE-Verfahrens, hergestellt werden/sein. Es ist somit bevorzugt, wenn die beiden Blindlöcher in dem Glassubstrat durch laserinduzierte Modifikation des Glassubstrats, insbesondere von zwei Seiten her, und durch eine nachfolgende gemeinsame nasschemische Ätzung angelegt wurden.

Die zuvor erläuterten beiden Blindlöcher können beispielsweise eine jeweilige Lochtiefe aufweisen, die weniger als 5 % voneinander abweichen. In diesem Fall sind die Blindlöcher somit im Wesentlichen gleich tief. In einem solchen Fall ist es möglich, dass ein geometrischer Schwerpunkt der Vertikalmembran näherungsweise in einer Mittelebene des Glassubstrats angeordnet ist. Dies ist beispielsweise günstig, um ein noch genauer zu erläuterndes Festkörpergelenk mittig in dem Glassubstrat anzuordnen.

Soll ein solches Festkörpergelenk hingegen exzentrisch in Bezug auf die besagte Mittelebene angeordnet sein, so können die beiden Blindlöcher auch eine jeweilige Lochtiefe aufweisen, die sich erheblich voneinander unterscheiden, also beispielsweise mehr als 20 %, insbesondere mehr als 50 %, voneinander abweichen. In einem solchen Fall kann also ein geometrischer Schwerpunkt der Vertikalmembran exzentrisch zu einer Mittelebene des Glassubstrats angeordnet sein. Durch Verändern der jeweiligen Lochtiefe lässt sich somit die Lage der Vertikalmembran entlang der Flächennormalen des Glassubstrats gezielt einstellen. Beispielsweise kann so eine erste Vertikalmembran in Nähe der Oberseite des Glassubstrats angeordnet werden, während eine zweite Vertikalmembran in Näher der Unterseite des Glassubstrats angeordnet sein kann.

Bei Verwendung von Blindlöchern kann auch vorgesehen sein, dass zwei sich gegenüberliegende Oberflächen der Vertikalmembran, die vorzugsweise jeweils achsparallel entlang einer Längsachse der Vertikalmembran und/oder jeweils in einem gleichen Taperwinkel zu einer Flächennormalen des Glassubstrats verlaufen, durch je ein zugehöriges Blindloch begrenzt sind. Auch hier kann wieder vorgesehen sein, dass die beiden Blindlöcher in gegensinniger Verlaufsrichtung ausgestaltet sind.

Das zuvor erläuterte Blindloch bzw. die zuvor erläuterten Blindlöcher kann/können jeweils wenigstens eine Lochwand aufweisen, die in einem Taperwinkel zu einer Flächennormalen des Glassubstrats verläuft. Hierbei kann der Taperwinkel insbesondere mehr als 1.0°, oder sogar mehr als 1.5°, betragen. Hierdurch kann somit erreicht sein, dass die Vertikalmembran schräg zur Substratebene verläuft. Dadurch kann insbesondere die Länge der Vertikalmembran geometrisch vergrößert werden, was günstig ist, um große Auslenkungen zu erzielen. Mittels des LIDE-Verfahrens ist es auch möglich, dass ein Querschnitt des jeweiligen Blindlochs in einer Vertikalebene quer zu einer Substratebene des Glassubstrats in Richtung auf einen jeweiligen zugehörigen Lochboden hin abnimmt. Auch eine solche Ausgestaltung ist sinnvoll, um große Auslenkungen zu ermöglichen, insbesondere von Rotationskörpern, die monolithisch mit der Vertikalmembran verbunden sind.

Wie noch anhand der Figuren klar werden wird, kann ein Lochboden des Blindlochs durch eine Außenseite des Glassubstrats, also insbesondere durch eine Oberseite oder eine Unterseite des Glassubstrats, begrenzt sein.

Eine Längsachse der Vertikalmembran kann quer, also insbesondere schräg, zu einer Substratebene des Glassubstrats verlaufen. Diese Längsachse wird zum Beispiel in einem xz-Querschnitt durch die Membran sichtbar mit der xy-Ebene als der Substratebene. Hierbei kann die Längsachse in einem Taperwinkel zu einer Flächennormalen (= Normale der Substratebene) des Glassubstrats verlaufen. Der Taperwinkel kann dabei durch eine Anisotropie der nass-chemischen Ätzung von modifizierten Bereichen des Glassubstrats definiert sein, die laserinduziert modifiziert wurden. Die jeweiligen Lochwände der beiden Blindlöcher können dabei jeweils den Taperwinkel zur Flächennormalen einschließen. Mit anderen Worten können also die beiden Blindlöcher mit gleicher Querschnittsform ausgebildet sein.

Wenigstens einer der Lochböden, vorzugsweise jedoch alle Lochböden, des jeweiligen Blindlochs können eine Verrundung im Zentrum des zugehörigen Blindlochs zeigen, die durch eine isotrope nass-chemische Schätzung erzielt wurde. Dies ist günstig, um Spitzen der mechanischen Spannung im Bereich des Lochbodens zu vermeiden, wodurch die mechanische Belastbarkeit der Vertikalmembran verbessert werden kann. Hierbei kann insbesondere ein Krümmungsradius der Verrundung durch einen Ätzradius der Isotopenätzung vorgegeben sein. Es ist dabei bevorzugt, wenn zur Ausbildung der Verrundung eine Lochtiefe des jeweiligen Blindlochs durch eine nasschemische Überätzung über eine Modifikationstiefe eines zum Blindloch zugehörigen modifizierten Bereichs (der vor der Ätzung laserinduziert modifiziert wurde) hinaus ausgedehnt wurde, sodass die Lochtiefe größer ausfällt als die Modifikationstiefe des zugehörigen modifizierten Bereichs.

Eine Hauptauslenkungsrichtung der Vertikalmembran kann quer, also insbesondere parallel, zur Substratebene verlaufen. Somit kann also die Vertikalmembran quer, insbesondere parallel, zur Substratebene ihre größte Auslenkbarkeit aufweisen.

Gemäß einer Ausgestaltung ist vorgesehen, dass wenigstens ein seitliches Ende der Vertikalmembran freistehend angelegt ist. Dadurch kann erreicht sein, dass dieses Ende bei entsprechender mechanischer Anregung eine Schwingung ausführen kann.

Zur Lösung der Aufgabe wird auch eine Doppel-Vertikalmembran-Anordnung gemäß Anspruch 8 vorgeschlagen mit wenigstens zwei sich gegenüberliegenden Vertikalmembranen, die jeweils wie zuvor beschrieben ausgestaltet sind, d.h. die jeweilige Vertikalmembran wurde jeweils aus einem Glassubstrat durch laserinduzierte Modifikation des Glassubstrats und nachfolgende nasschemische Ätzung freigelegt, sodass die jeweilige Membran als eine Vertikalmembran ausgestaltet ist und sodass eine jeweilige Ebene der jeweiligen Vertikalmembran quer zu einer Substratebene des Glassubstrats verläuft. Dem erfindungsgemäßen Konzept folgend, sind bei dieser Anordnung die beiden Vertikalmembrane über eine freistehende Brücke miteinander verbunden, die monolithisch im Glassubstrat mittels eines (insbesondere mittigen) Blindlochs definiert bzw. ausgebildet ist. Hierbei ist es bevorzugt, wenn das (mittige) Blindloch je eine innere Oberfläche der jeweiligen der beiden Vertikalmembranen begrenzt. Eine jeweilige äußere Oberfläche der beiden Vertikalmembranen kann dabei durch je ein äußeres Blindloch begrenzt sein. Hierbei ist es vorzuziehen, wenn das mittige Blindloch gegensinnig zu den beiden äußeren Blindlöchern verläuft. Die beiden inneren Oberflächen der beiden sich direkt gegenüberliegenden Vertikalmembranen können sich dabei direkt gegenüberliegen, sodass nur ein Hohlraum des mittigen Blindlochs zwischen den beiden Vertikalmembranen besteht. Ferner kann wenigstens eines der äußeren Blindlöcher einseitig durch einen (unbearbeiteten) Körper (engl. bulk) des Glassubstrats begrenzt sein.

Vorteilhaft an einer solchen Doppel-Vertikalmembran-Anordnung ist, dass damit eine hochpräzise mikromechanische Aktorik implementiert werden kann, wie aus den Ausführungsbeispielen ersichtlich werden wird. Insbesondere können mittels einer oder mehrerer solcher Doppel-Vertikalmembran-Anordnungen monolithische Feder-, Biege-, und Torsionselemente, sowie Festkörpergelenke, insbesondere ausgestaltet als Drehgelenke, ausgebildet werden.

Die Doppel-Vertikalmembran-Anordnung kann beispielsweise eine Vielzahl an sich jeweils gegenüberliegenden Vertikalmembranen aufweisen, die entlang einer Längsrichtung aufgereiht sind.

Dadurch kann erreicht sein, dass eine monolithische Federstruktur ausgestaltet ist. Die Federstruktur kann dabei, je nach Auslegung und/oder Anzahl der Vertikalmembranen, reversibel entlang der Längsrichtung und/oder in einer Torsion um die Längsrichtung verformbar sein. D.h., die Federstruktur kann als Linear- und/oder als Torsionsfeder dienen.

Es wird somit insbesondere eine Vertikalmembran aus Glas wie zuvor beschrieben , und zwar als Teil einer wie soeben beschriebenen Doppel-Vertikalmembran-Anordnung, insbesondere als Teil einer wie zuvor beschriebenen Linear- oder Torsionsfeder aus Glas.

Bei einer solchen Doppel-Vertikalmembran-Anordnung kann erfindungsgemäß auch vorgesehen sein, dass die beiden Vertikalmembranen symmetrisch um eine Mittelachse ausgestaltet sind. Hierbei ist es vorzuziehen, wenn die Mittelachse mit einer Flächennormalen des Glassubstrats zusammenfällt. Dies kann beispielsweise derart ausgestaltet sein, dass die freistehende Brücke, die die beiden Vertikalmembrane miteinander verbindet, parallel zur Substratebene auslenkbar ist, obwohl die Längsachsen der beiden Biegestrukturen einen Winkel zueinander bilden.

Die Doppel-Vertikalmembran-Anordnung kann ferner zu beiden Seiten (also links und rechts) über einen jeweiligen Lochboden eines jeweiligen äußeren Blindlochs monolithisch mit dem Glassubstrat verbunden sein.

Ferner sind Ausgestaltungen möglich, bei denen zwei aufeinander folgende Vertikalmembrane durch einen Lochboden verbunden sind, der oberhalb und unterhalb von einem jeweiligen Blindloch begrenzt ist, wie noch an einem Beispiel gezeigt werden wird.

Eine Alternative Ausgestaltung hierzu sieht vor, dass die Doppel-Vertikalmembran-Anordnung nur einseitig über einen Lochboden eines äußeren Blindlochs monolithisch mit dem Glassubstrat verbunden ist. Dies kann beispielsweise zweckhaft sein, um so ein freistehendes Ende der Anordnung auszubilden. Dieses freistehende Ende kann dann aus der Substratebene heraus und/oder in Längsrichtung der Doppel-Vertikalmembran-Anordnung und/oder in einer Drehung um die Längsrichtung auslenkbar sein.

Mittels wenigstens drei aufeinander folgender erfindungsgemäßer Vertikalmembrane (die wie zuvor beschrieben oder wie hier beansprucht ausgestaltet sein können) und/oder mittels wenigstens zwei aufeinanderfolgender Doppel-Vertikalmembran-Anordnungen, wie sie zuvor beschrieben wurden, kann eine mäandrierende mikromechanische Federstruktur aus Glas erhalten werden, die sich vielseitig einsetzen lässt. Hierbei kann vorgesehen sein, dass wenigstens eine mittlere Vertikalmembran der Federstruktur links und rechts jeweils mit einer jeweiligen freistehenden Brücke der wenigstens zwei Doppel-Vertikalmembran-Anordnungen monolithisch verbunden ist. Es kann ferner eine rechte und/oder eine linke äußere Vertikalmembran mit einem Lochboden eines äußeren Blindlochs monolithisch verbunden sein, wobei das jeweilige äußere Blindloch (jeweils) einseitig durch einen Körper (engl. bulk) des Glassubstrats begrenzt ist. Damit eröffnen sich zahlreiche Möglichkeiten, erfindungsgemäße Vertikalmembrane für Mikro-Aktorik und Mikro-Sensorik einzusetzen.

Zur Lösung der Aufgabe wird auch eine spezifische Verwendung einer Vertikalmembran aus Glas vorgeschlagen gemäß Anspruch 12. Hierbei ist die Vertikalmembran nach einem der auf eine Glas-Membran gerichteten Ansprüche 1 bis 7 ausgestaltet. Die Verwendung sieht nun vor, dass die Vertikalmembran zur Ausbildung eines monolithischen Festkörpergelenks aus Glas eingesetzt wird. Zu dem gleichen Zweck kann auch eine erfindungsgemäße Doppel-Vertikalmembran-Anordnung gemäß einem der Ansprüche 8 bis 10, wie sie zuvor beschrieben wurde, eingesetzt werden.

Ein solches monolithisches Festkörpergelenk aus Glas kann so ausgestaltet sein, dass es eine Rotation erlaubt um eine Rotationsachse, die quer zu einer Längsachse der Vertikalmembran (und damit auch quer zu einer Flächennormalen des Glassubstrats) ausgerichtet ist. Hierdurch werden völlig neuartige Anwendungen ermöglicht, wobei aufgrund der monolithischen Ausgestaltung des Festkörpergelenks eine hohe Zuverlässigkeit der Rotationsbewegung erreicht werden kann. Insbesondere tritt keinerlei Spiel auf, wie dies bei Verwendung von Lagern häufig der Fall ist. Die monolithische Realisierung ermöglicht zudem eine extreme Miniaturisierung, wie dies etwa von herkömmlichen planaren MEMS-Ansätzen bekannt ist, jedoch mit dem Unterschied, dass die Festkörpergelenke in der Tiefe des Substrats angelegt werden können. Somit kann sich ein solches erfindungsgemäßes Festkörpergelenk beispielsweise dadurch auszeichnen, dass seine Rotationsachse in einer Tiefe des Glassubstrats verläuft, die wenigstens 10%, 20% oder sogar 30% der Dicke des Glassubstrats beträgt. Es sei zum besseren Verständnis nochmals erläutert, dass die besagte Rotationsachse des Festkörpergelenks parallel zur Substratebene verlaufen kann, jedoch beabstandet von der Ober- und/oder Unterseite des Glassubstrats.

Bei einer solchen Verwendung können auch zwei wie zuvor erläuterte Festkörpergelenke jeweils mittels einer erfindungsgemäßen Vertikalmembran monolithisch in einem Glassubstrat ausgebildet werden. Durch eine solche Anordnung von zwei Festkörpergelenken innerhalb des Glassubstrats kann erreicht werden, dass ein an den beiden Festkörpergelenken aufgehängter Rotationskörper relativ zum Glassubstrat und aus einer Substratebene des Glassubstrats heraus rotiert werden kann. Die Aufhängung des Rotationskörpers kann hierbei vorzugsweise monolithisch realisiert sein, sodass also auch der Rotationskörper selbst aus dem Glassubstrat mittels des LIDE-Verfahrens hergestellt sein kann. Es ist aber auch möglich, den Rotationskörper separat zu gestalten und anschließend mit einer geeigneten Verbindungstechnik (zum Beispiel Kleben oder Bonden) mit dem monolithisch ausgebildeten Festkörpergelenk (zumindest indirekt) zu verbinden und somit an diesem mechanisch aufzuhängen.

Bei der zuvor erläuterten Verwendung von zwei erfindungsgemäßen Festkörpergelenken können hierzu die jeweiligen Rotationsachsen der Festkörpergelenk achsparallel ausgestaltet sein. Denn dies ermöglicht eine reine Rotationsbewegung des Rotationskörpers ohne sonstige Torsion. Ferner kann vorgesehen sein, dass eine Verbindungslinie, die die beiden Rotationsachsen verbindet (und vorzugsweise jeweils rechtwinklig auf der jeweiligen Rotationsachse steht) einen Winkel einschließt zu der Substratebene des Glassubstrats. Dies ist beispielsweise dann der Fall, wenn die beiden Festkörpergelenke, genauer deren Rotationsachsen, in unterschiedlichen Tiefen in dem Glassubstrat (bezogen zum Beispiel auf die Oberseite des Glassubstrats) ausgebildet werden.

Ein weiterer attraktiver Anwendungsfall der hier vorgestellten Erfindung, der also mithilfe erfindungsgemäßer Vertikalmembran realisiert werden kann, sieht vor, dass ein Translationskörper jeweils links und rechts mittels je zwei derartiger Festkörpergelenke an einem Glassubstrat aufgehängt ist oder wird. Denn dieser Ansatz ermöglicht es, eine Bewegung in einer Substratebene des Glassubstrats (verursacht beispielsweise durch eine Kompression des Glassubstrats, insbesondere durch Druck auf die Substratenden, oder eine Dekompression/Dilatation des Glassubstrats, insbesondere durch Zug an den Substratenden) mittels der vier Festkörpergelenke (die die Verbindung zum Translationskörper herstellen) in eine gleichmäßige, vorzugweise rotationsfreie, Hubbewegung des Translationskörpers entlang einer Flächennormalen des Glassubstrats umzusetzen. Dadurch kann insbesondere erreicht werden, dass der Translationskörper linear aus der Substratebene in einer, insbesondere stufenlosen / gleichmäßigen / kontinuierlichen Translationsbewegung heraus bewegt werden kann. Eine solche Verwendung ist insbesondere dann möglich, wenn der Translationskörper jeweils über einen jeweiligen Rotationskörper (wie zuvor beschrieben) mit dem Glassubstrat verbunden ist, wobei auch diese Verbindung vorzugsweise wieder monolithisch ausgestaltet sein kann, sodass dann also auch der Translationskörper als auch die Rotationskörper jeweils monolithisch aus dem Glassubstrat mittels des LIDE-Verfahrens hergestellt sind.

Zur Lösung der eingangs genannten Aufgabe sind ferner erfindungsgemäß die Merkmale des unabhängigen Verfahrensanspruchs 14 vorgesehen. Insbesondere wird somit erfindungsgemäß zur Lösung der Aufgabe bei einem Verfahren der eingangs beschriebenen Art vorgeschlagen, dass zum Freistellen der Vertikalmembran wenigstens ein Blindloch in dem Glassubstrat durch laserinduzierte Modifikation des Glassubstrats und nachfolgende nasschemische, vorzugsweise hochgradig anisotrope, Ätzung angelegt wird, sodass das wenigstens eine Blindloch einen monolithischen Lochboden ausbildet. Ferner ist vorgesehen, dass das wenigsten eine Blindloch eine Oberfläche der Vertikalmembran definiert, die beispielsweise quer zu einer Substratebene des Glassubstrats verläuft und/oder quer zu einer Hauptauslenkungsrichtung der Vertikalmembran verläuft und/oder eine Längsrichtung der Vertikalmembran vorgibt.

Alternativ oder aber ergänzend zu den zuvor erläuterten Merkmalen kann bei einem wie eingangs beschriebenen Verfahren zur Lösung der Aufgabe aber auch vorgesehen sein, dass zwei gegenläufige und lateral zueinander versetzte Blindlöcher in dem Glassubstrat durch laserinduzierte Modifikation des Glassubstrats und nachfolgende nasschemische Ätzung angelegt werden, um die Vertikalmembran freizustellen, wie es in Anspruch 15 beschrieben ist. Ein solcher Ansatz kann insbesondere darin resultieren, dass eine Längsachse der Vertikalmembran in Richtung jeweiliger Lochwände der beiden Blindlöcher verläuft. Ferner können hierbei die Lochwände in einem jeweiligen, vorzugweise gleichen, Taperwinkel zu einer Flächennormalen des Glassubstrats verlaufen, sodass die Vertikalmembran eine gleichbleibende Membrandicke zeigt.

Bei den zuvor erläuterten Verfahren kann ferner vorgesehen sein, dass das wenigstens eine Blindloch durch anisotrope nasschemische Ätzung eines zugehörigen modifizierten Bereichs im Glassubstrat angelegt wird. Hierbei kann vorzugsweise zur Ausbildung einer Verrundung im Zentrum des jeweiligen Lochbodens des jeweiligen Blindlochs nachfolgend eine isotrope Ätzung eines nicht-modifizierten Bereichs durchgeführt werden. Beispielsweise kann hierzu eine Überätzung durchgeführt werden, sodass eine Lochtiefe des jeweiligen Blindlochs über eine Modifikationstiefe des korrespondierenden modifizierten Bereichs, der vor der Ätzung laserinduziert modifiziert wurde, hinaus ausgedehnt wird. Im Ergebnis kann so ein Krümmungsradius der Verrundung einem Ätzradius der isotropen Ätzung entsprechen.

Es kann ferner je nach Prozessführung vorgesehen sein, dass die Vertikalmembran durch die nasschemische Ätzung von beiden Seiten des Glassubstrats her freigelegt wird. Dies ist vorteilhaft, um eine effiziente Herstellung zu ermöglichen. Hierbei ist es bevorzugt, wenn das Glassubstrat vor der nasschemischen Ätzung mittels Laserpulsen modifiziert wird, die von zwei Seiten ausgehend, also in gegenläufigen Richtungen, in das Glassubstrat eingebracht werden. Hierbei kann jeweils ein identisches Laserprofil verwendet werden und/oder eine gleiche Z-Fokuslage (des Lasers). Es ist ferner bevorzugt, wenn hierzu dieselbe Laserquelle verwendet wird und das Glassubstrat zwischen zwei Belichtungsschritten gedreht wird. Um dabei eine exakte Ausrichtung der Blindlöcher zueinander zu ermöglichen, kann ein zweites Einbringen der Laserpulse (= zweiter Belichtungsschritt) von einer Unterseite des Glassubstrats her anhand wenigstens einer Alignment-Struktur erfolgen, die zuvor mittels eines ersten Einbringens von Laserpulsen (= erster Belichtungsschritt) von einer Oberseite des Glassubstrats her angelegt wurde. Es versteht sich, dass Oberseite und Unterseite hier austauschbar sind, da dies unterschiedlich definiert sein kann.

Zum Ausbilden der Vertikalmembran können also wenigstens zwei gegenläufige Blindlöcher in dem Glassubstrat als laserinduzierte Modifikation in dem Glassubstrat angelegt werden. Dies kann durch Belichten des Glassubstrats mit einem Laser von zwei Seiten her erfolgen, und zwar insbesondere mittels eines zweistufigen Belichtungsprozesses. Nachfolgend können dann die Blindlöcher in einem gemeinsamen nasschemischen Ätzschritt freigeätzt werden.

Es zeigt:
- Fig. 1: ein erstes Beispiel einer erfindungsgemäß ausgestalteten Vertikalmembran, wobei die Vertikalmembran Teil einer Doppel-Vertikalmembran-Anordnung ist,
- Fig. 2: eine mäandrierende beidseitig monolithisch aufgehängte mikromechanische Federstruktur aus Glas, die durch Aneinanderreihung mehrerer erfindungsgemäß ausgestalteter Vertikalmembrane entstanden ist,
- Fig. 3: ein weiteres Beispiel einer mikromechanischen Federstruktur aus Glas, die mehrere Doppel-Vertikalmembran-Anordnungen und mehrere Vertikalmembrane aufweist,
- Fig. 4: eine einseitig freigestellte mikromechanische Federstruktur aus Glas auf Basis erfindungsgemäßer Vertikalmembrane,
- Fig. 5-7: ein weiteres Beispiel einer mikromechanischen Federstruktur, die erfindungsgemäße Vertikalmembrane verwendet,
- Fig. 8-10: ein weiteres Beispiel, wie Vertikalmembrane in einem Glassubstrat angelegt sein können, um mehrere Biegestrukturen 2 in Form von Federbalken zu definieren,
- Fig. 11: einen Querschnitt (vergleichbar dem der Figur 1) durch eine mäandrierende mikromechanische Federstruktur auf Basis erfindungsgemäßer Vertikalmembrane,
- Fig. 12: eine analoge Federstruktur wie die Figur 11, wobei hier die Lochtiefe der Blindlöcher reduziert wurde,
- Fig. 13: eine weitere mikromechanische Federstruktur mit Vertikalmembranen, die einen vergleichsweise großen Abstand in der x-Richtung zeigen,
- Fig. 14: eine analoge Federstruktur zu derjenigen der Figur 13, wobei hier die räumliche Frequenz der Vertikalmembrane erhöht wurde durch Verringerung der Breite der Blindlöcher,
- Fig. 15: illustriert die Verwendung der erfindungsgemäßen Vertikalmembran, um zwei Festkörpergelenke auszubilden und so eine Rotation eines Rotationskörpers zu ermöglichen,
- Fig. 16: eine erfindungsgemäße Anordnung aus mehreren Vertikalmembranen, die es ermöglichen, eine Bewegung in der Ebene des Glassubstrats in eine Translationsbewegung aus der Substratebene heraus umzusetzen,
- Fig. 17: illustriert unterschiedliche Ätzstadien beim nasschemischen Freiätzen eines Blindlochs durch laserinduziertes Ätzen,
- Fig. 18: eine weitere mögliche Ausgestaltung einer erfindungsgemäßen Federstruktur unter Verwendung mehrerer erfindungsgemäßer Vertikalmembranen,
- Fig. 19: ein Beispiel einer erfindungsgemäßen Federstruktur, die vergraben innerhalb eines Glassubstrats angeordnet ist, und schließlich
- Fig. 20: eine Rasterelektronenmikroskop-Aufnahme einer erfindungsgemäß ausgestalteten monolithischen Vertikalmembran aus Glas.

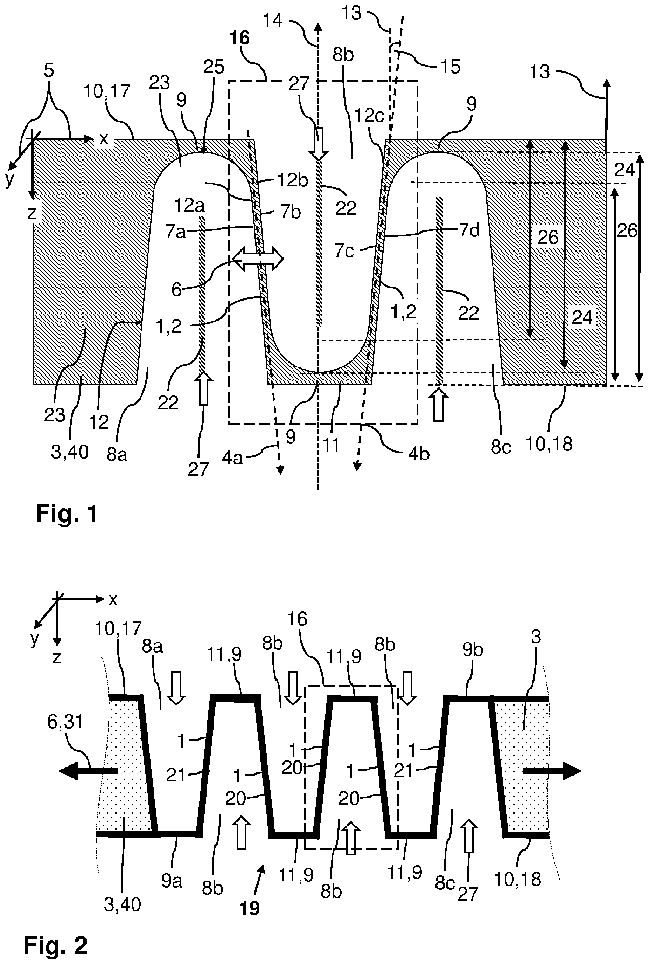

Die Figur 1 zeigt einen Querschnitt entlang der xz-Ebene durch ein Glassubstrat 3, dessen Oberseite 17 eine Substratebene 5 (xy-Ebene) definiert. Wie durch die schraffierten Flächen gezeigt ist, die modifizierte Bereiche 22 innerhalb des Glassubstrats 3 anzeigen, wurde mithilfe eines jeweiligen Laserpulses 27 eine Materialänderung (Modifikation) in den Glaskörper 40 des Glassubstrats 3 eingebracht. Hierzu wurde das Glassubstrat 3 mittels eines zweistufigen Belichtungsprozesses mit einem Laser sowohl von der Oberseite 17 her als auch anschließend von der Unterseite 18 her belichtet. Wie anhand der Blockpfeile in Figur 1 illustriert ist, wurden somit Laserpulse 27 in gegenläufigen Richtungen in das Glassubstrat 3 eingebracht, um so eine jeweilige laserinduzierte Modifikation in das Glassubstrat 3 einzubringen.

Wie man ebenfalls in Figur 1 sieht, wurde dadurch der jeweilige modifizierte Bereich 22 mit dem jeweiligen Laserpuls 27 bis zu einer Modifikationstiefe 26, gemessen von der jeweiligen Außenseite 10 des Glassubstrats 3, angelegt. Die so modifizierten Bereiche 22 wurden nachfolgend in einem gemeinsamen nasschemischen Ätzschritt freigelegt. Dadurch entstanden zunächst Blindlöcher 8a, 8b und 8c. Aufgrund der eingebrachten Modifikation schreitet dabei die (eigentlich isotrope) nasschemische Ätzung in den modifizierten Bereichen 22 sehr viel schneller voran als in den nicht-modifizierten Bereichen 23 des Glassubstrats 3, sodass im Ergebnis hochgradig anisotrop geätzt werden kann. Dieses laserinduzierte Ätzverfahren kann unter dem Begriff LIDE (= laser induced deep etching) zusammengefasst werden.

Wie man ferner in Figur 1 erkennt, wurden zur Ausbildung einer jeweiligen Verrundung 25 im Zentrum des jeweiligen Lochbodens 9 des jeweiligen Blindlochs 8a, 8b, 8c eine starke Überätzung ausgeführt, wodurch nicht-modifizierte Bereiche 23 des Glassubstrats 3 isotrop geätzt wurden. Dies erkennt man beispielsweise in Figur 1 daran, dass die jeweilige Breite des Blindlochs 8 am bodenseitigen Ende größer ausfällt als die Breite des modifizierten zugehörigen Bereichs 22, jeweils gemessen in der x-Richtung.

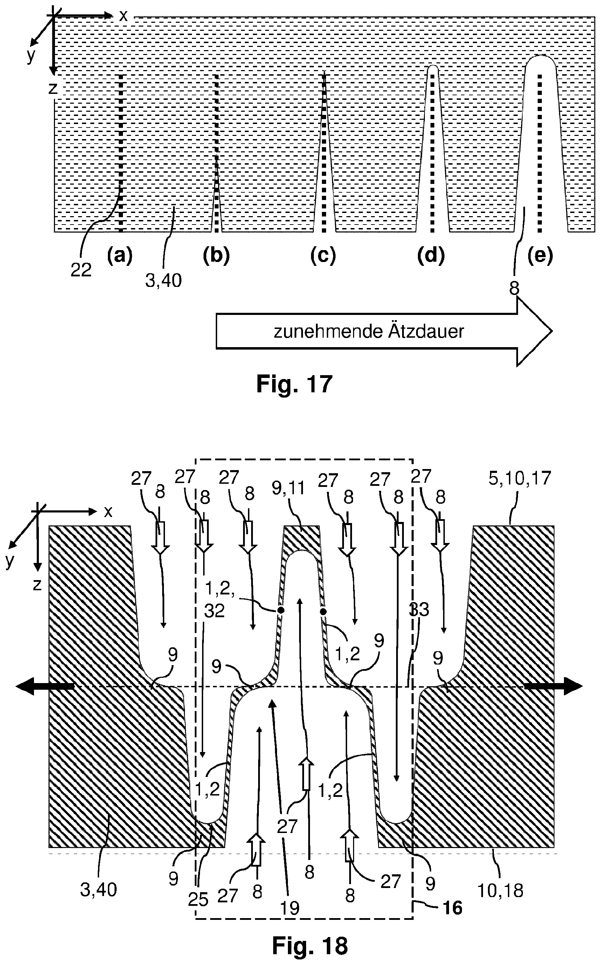

Die einzelnen Stadien beim laserinduzierten Ätzen sind dabei in Figur 17 illustriert: (a) mittels Laser modifizierter Bereich 22; (b) nasschemisch angeätzt; (c) bis auf die Modifikationstiefe 26 geätzt; (d) leicht überätzt (Ätztiefe übersteigt die Modifikationstiefe 26); (e) stark überätzt (und damit Ausbildung einer Verrundung 25 ähnlich wie in Figur 1 schematisch angedeutet).

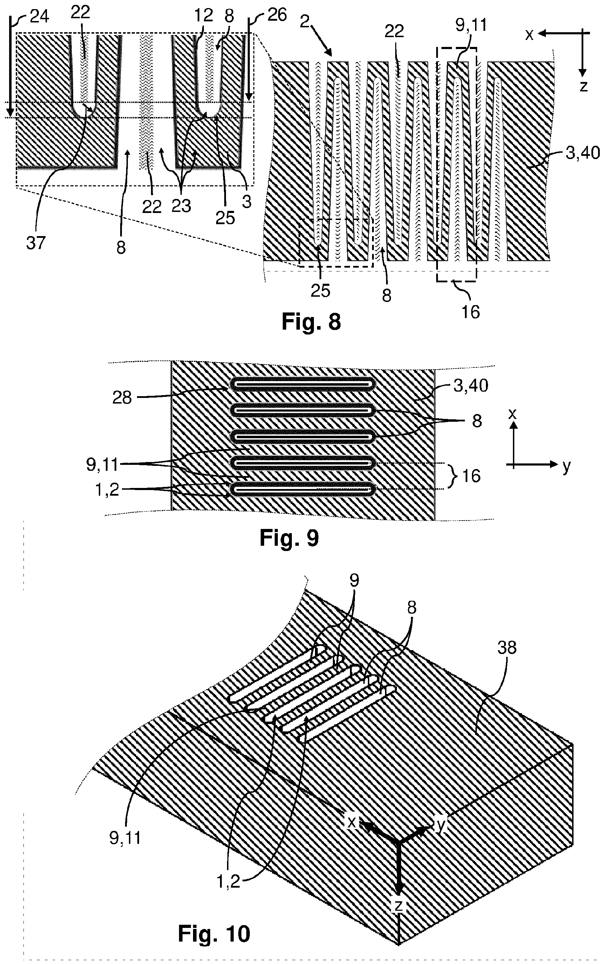

Diese Überätzung führt somit insbesondere dazu, dass die jeweilige Lochtiefe 24 des jeweiligen Blindlochs 8 größer ausfällt als die korrespondierende Modifikationstiefe 26 (Vgl. Figur 1). Das Ergebnis der Überätzung ist auch gut in dem linken Detail der Figur 8 zu erkennen: Dort sieht man, dass der Krümmungsradius der Verrundung 25 einem Ätzradius 37 der isotropen Ätzung entspricht.

Im Ergebnis wurde so bei dem Beispiel der Figur 1, zwei Membrane 1 aus dem gezeigten Glassubstrat 3 durch laserinduzierte Modifikation des selbigen und nachfolgende nasschemische Ätzung freigelegt. Da die Ebene dieser jeweiligen Membran 1 quer zu der Substratebene 5 des Glassubstrats 3 verläuft, wurde somit eine Vertikalmembran 1 monolithisch in dem Glassubstrat 3 ausgestaltet. Wie der horizontale Blockpfeil in Figur 1 anzeigt, verläuft die Hauptauslenkungsrichtung 6 dieser Vertikalmembran 1 quer zu einer Flächennormalen 13 des Glassubstrat 3. Hierbei sind die beiden Oberflächen 7a und 7b, die die linke Vertikalmembran 1 definieren beziehungsweise begrenzen und die jeweils quer zu der Hauptauslenkungsrichtung 6 verlaufen, durch das Blindloch 8a bzw. das Blindloch 8b begrenzt. Genauer ist sowohl die linke Vertikalmembran 1 als auch die rechte Vertikalmembran 1 jeweils durch zwei lateral zueinander versetzte und gegenläufige Blindlöcher 8 (links: 8a und 8b; rechts: 8b und 8c) begrenzt.

Die Hauptauslenkungsrichtung 6 der Vertikalmembran 1 verläuft somit parallel zur Substratebene 5 (bzw. senkrecht zum Taperwinkel 15) und nicht etwa quer zu dieser, wie dies bei typischen horizontal verlaufenden Membranen der Fall ist. Die Vertikalmembran 1 weist quer zur Substratebene 5 ihre größte Auslenkungen auf, weil die Vertikalmembran 1 in der y- und z-Richtung wesentlich größer ausgedehnt ist als in der x-Richtung: Bei dem Beispiel der Figur 1 weisen die beiden Vertikalmembranen 1 in der x-Richtung eine jeweilige Membrandicke von weniger als 30 µm auf, wobei die Membrandicke beispielsweise sogar weniger als 10pm aufweisen kann. Die Dimension der jeweilige Vertikalmembran 1 in der y-Richtung kann hingegen mehrere 100 µm oder sogar mehr als 1 mm, beispielsweise bis zu 1 cm oder sogar mehrere cm betragen. In der z-Richtung kann die Länge der Vertikalmembran 1 in derselben Größenordnung liegen wie die Dicke des Glassubstrats 3, wie man in Figur 1 nachvollziehen kann.

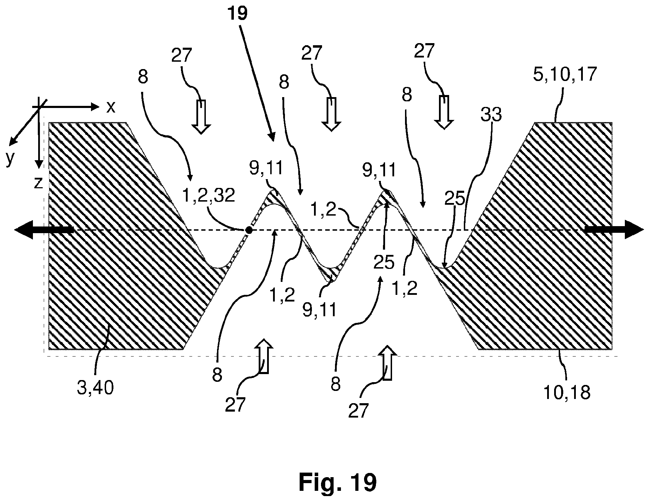

Jedes der in Figur 1 gezeigten Blindlöcher 8a, 8b und 8c bildet dabei jeweils einen monolithischen Lochboden 9 aus, der mit der jeweiligen Vertikalmembran 1 verbunden ist. Beispielsweise ist die rechte Membran 1, die rechts durch das Blindloch 8c begrenzt ist, am oberen Ende über den Lochboden 9 monolithisch mit dem Glassubstrat 3 verbunden. Der jeweilige Lochboden 9 ist dabei jeweils durch die obere oder untere Außenseite 10 des Glassubstrat 3 begrenzt. Dies müsste aber nicht zwingend gegeben sein; beispielsweise wäre es auch möglich, die Lochtiefe 26 des jeweiligen Blindlochs 8 nur halb so groß wie die Substratdicke anzulegen und gleichzeitig an derselben Stelle (also ohne oder mit geringem lateralen Versatz in x- und y-Richtung) ein weiteres Blindloch 8 von der Gegenseite her anzulegen. In diesem Fall würde sich der so entstehende Lochboden 9 in der Tiefe des Glassubstrats 3 befinden und wäre somit gerade nicht durch eine Außenseite 10 des Glassubstrats begrenzt, wie dies in der Figur 18 gezeigt ist. Durch Anlegen von modifizierten Bereichen 22 jeweils oberhalb und unterhalb des zu definierenden Lochbodens 9 des jeweiligen Blindlochs 8 kann somit der Lochboden 9 in die Tiefe des Glassubstrat 3 hinein verlegt werden, wie dies etwa auch in dem Beispiel der Figur 19 gezeigt ist.

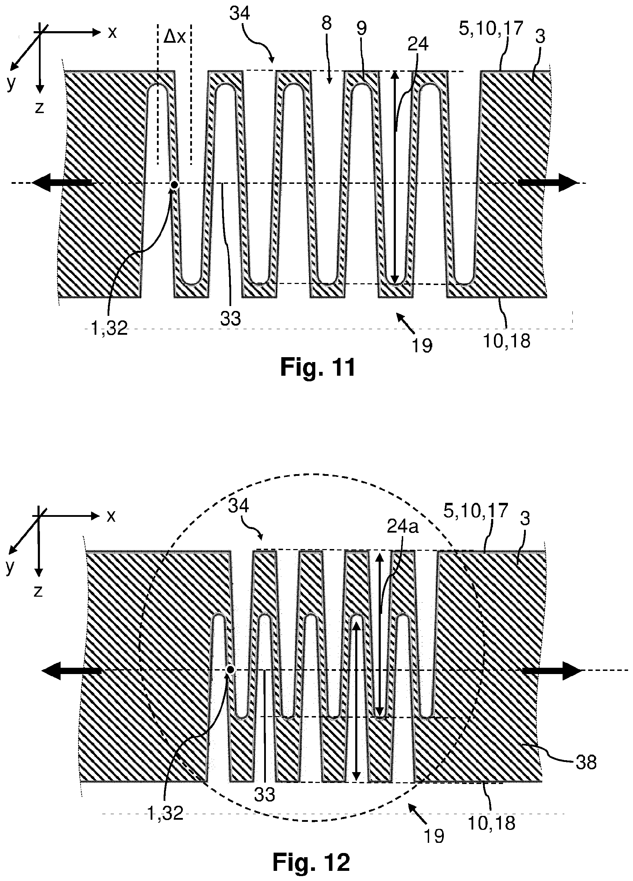

Bei dem Beispiel der Figur 1 wurden die drei Blindlöcher 8a, 8b und 8c, abgesehen von geringen Prozessschwankungen, jeweils mit gleicher Lochtiefe 24 (gemessen von der jeweiligen Außenseite 10 aus) ausgestaltet. Dadurch liegt der jeweilige geometrische Schwerpunkt 32 der jeweiligen Vertikalmembran 1 näherungsweise in einer Mittelebene 33 des Glassubstrats 3, wie dies etwa in Figur 11 für einen ähnlichen Fall illustriert ist. Dies gilt aber auch beispielsweise für die vier Vertikalmembrane 1 bei dem Beispiel der Figur 19. Das Beispiel der Figur 18 zeigt hingegen, dass auch Ausgestaltungen möglich sind, bei denen der jeweilige geometrische Schwerpunkt 32 der jeweiligen Vertikalmembran 1 versetzt (nach oben oder unten) zu einer Mittelebene 33 des Glassubstrats 3 angeordnet ist.

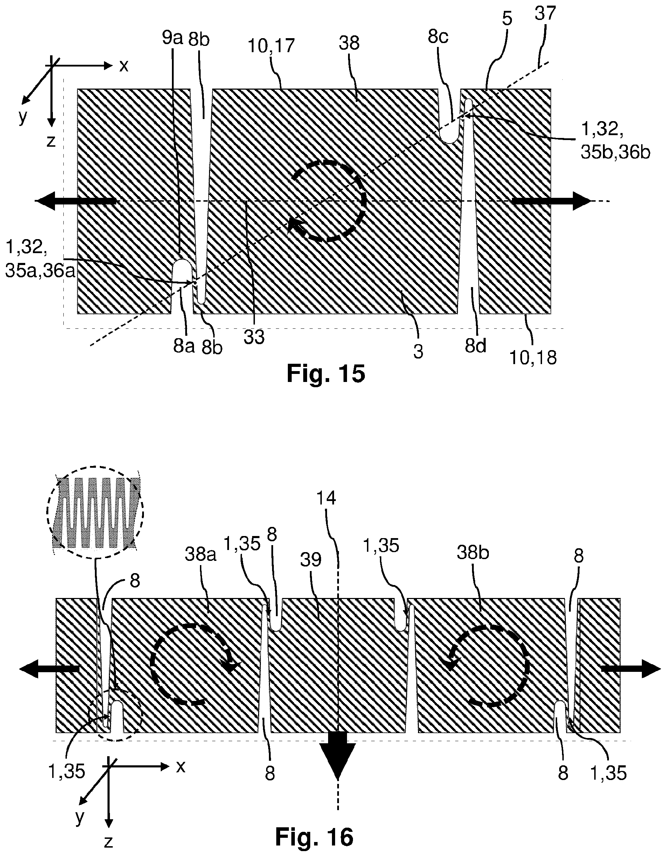

Die Figur 15 zeigt demgegenüber ein Ausgestaltungsbeispiel einer erfindungsgemäßen Vertikalmembran 1, die durch zwei gegenläufig verlaufende Blindlöcher 8a und 8b definiert ist, wobei diese beiden Blindlöcher 8a und 8b eine jeweilige Lochtiefe 24 aufweisen, die mehr als 50% voneinander abweichen. Da gerade das untere Blindloch 8a sehr kurz gehalten ist, wird dadurch die linke Vertikalmembran 1 vergleichsweise nahe an der Unterseite 18 des Glassubstrats 3 angeordnet, sodass der geometrische Schwerpunkt 32 dieser Vertikalmembran 1 exzentrisch zu der gezeigten Mittelebene 33 angeordnet ist. Der Schwerpunkt 32 der Vertikalmembran eins weist dabei einen Abstand zur Unterseite 18 auf, welcher weniger als 25% der Substratdicke beträgt (d.h. der Schwerpunkt 32 liegt im unteren Viertel des Glassubstrats 3).

In Figur 1 kann man auch gut erkennen, dass die beiden sich gegenüberliegenden Oberflächen 7a und 7b der linken Vertikalmembran 1 jeweils achsparallel verlaufen, und zwar entlang der gezeigten Längsachse 4a der linken Vertikalmembran 1. Die beiden Oberflächen 7a und 7b schließen dabei jeweils einen Taperwinkel 15 zu der Flächennormalen 13 des Glassubstrats 3 ein.

Aus einem anderen Blickwinkel betrachtet weist jedes der gezeigten Blindlöcher 8a, 8b und 8c in Figur 1 jeweils wenigstens eine Lochwand 12 (siehe z.B. die Lochwände 12a und 12b) auf, die in einem Taperwinkel 15 zu der Flächennormalen 13 verlaufen. Hierbei beträgt der Taperwinkel bei dem Beispiel der Figur 1 mehr als 1,5°. Ferner erkennt man auch gut, dass der jeweilige Querschnitt des jeweiligen Blindlochs 8 in der gezeigten xz-Vertikalebene (also quer zur Substratebene 5) in Richtung auf den jeweiligen zugehörigen Lochboden 9 hin abnimmt. Beispielsweise erkennt man bei dem mittleren Blindloch 8b, dass dort die jeweiligen Lochwände 12, die durch die Oberflächen 7b und 7c gegeben sind, aufeinander zu laufen, sodass sich die Breite des Blindlochs 8b in der x-Richtung mit zunehmender z-Tiefe verringert. Wie in den noch folgenden Ausführungsbeispielen noch besser ersichtlich werden wird, kann dabei das jeweilige Blindloch 8 (zum Beispiel alle Blindlöcher der Figur 1) quer zu der Hauptauslenkungsrichtung 6, also in Figur 1 in y-Richtung, länger ausgestaltet sein als das jeweilige Blindloch 8 in Richtung der Flächennormalen 13 (also in z-Richtung in Figur 1) tief ist. Blickt man also von oben auf die xy-Ebene 5, so würde man erkennen, dass das Blindloch 8b einen nicht-kreisrunden Querschnitt quer zu seiner z-Längsrichtung aufweist.

In Figur 1 erkennt man auch gut, dass die Längsachse 4 der Vertikalmembran 1 schräg zu der xy-Substratebene 5, also quer zu dieser, verläuft, wobei die Längsachse 4 den Taperwinkel 15 zur Flächennormalen 13 einschließt. Der Taperwinkel 15 resultiert dabei aus der Tatsache, dass aufgrund der laserinduzierten Modifikation die nasschemische Ätzung in den modifizierten Bereichen 22 hochgradig anisotrop abläuft, sodass die Ätzung dort in der z-Richtung wesentlich schneller voranschreitet als in der x-Richtung und als in der y-Richtung.

Man erkennt ferner in Figur 1, dass drei Blindlöcher 8a, 8b und 8c jeweils mit gleicher Querschnittsform in Bezug auf die xz-Ebene ausgestaltet sind; die jeweiligen Lochwände 12 schließen dabei stets den Taperwinkel 15 zur Flächennormalen 13 ein, da alle diese Blindlöcher 8 mittels eines gemeinsamen nasschemischen Ätzschritts und unter vorheriger Verwendung gleichartiger Laserpulse 27 angelegt wurden.

Zudem zeigen alle gezeigten Lochböden 9 in Figur 1 eine gleichartige Verrundung 25 im Zentrum des jeweiligen Blindlochs 8, die, wie bereits erläutert wurde, durch eine isotrope nasschemische Überätzung (also über die Modifikationstiefe 26 der modifizierten Bereiche 22 hinaus) erzielt wurde.

Das in Figur 1 gezeigte Ausgestaltungsbeispiel kann auch als eine Doppel-Vertikalmembran-Anordnung 16 aufgefasst werden.

Denn die beiden sich gegenüberliegenden Vertikalmembran 1, die jeweils achsensymmetrisch zu der gezeigten Mittelachse 14 verlaufen, sind über eine freistehende (monolithische) Brücke 11 miteinander verbunden. Diese Brücke 11 wird durch den Lochboden 9 des mittleren Blindlochs 8b ausgebildet, ist somit monolithisch in dem Glassubstrat 3 ausgebildet und mittels des mittigen Blindlochs 8b definiert. Hierbei begrenzt das mittige Blindloch 8b sowohl die rechte Oberfläche 7B der linken Membran 1 als auch die linke Oberfläche 7c der rechten Membran 1. Ferner verläuft das mittige Blindloch 8b gegensinnig zu den beiden äußeren Blindlöchern 8a und 8c. Die äußeren Blindlöcher 8a und 8c sind hingegen einseitig durch den Körper 40 des Glassubstrats 3 begrenzt.

Wie man in Figur 1 erkennt, fällt dabei die gezeigte Mittelachse 14 gerade mit der Flächennormalen 13 des Glassubstrat 3 zusammen. Daher verläuft auch die Brücke 11 parallel zur Substratebene 5 und ist somit in der Substratebene 5 auslenkbar, obwohl die gezeigten Längsachsen 4a und 4b der beiden Vertikalmembranen 1 einen Winkel zueinander bilden (der gerade dem Doppelten des Taperwinkels 15 entspricht). Die beiden in Figur 1 gezeigten Vertikalmembranen 1 können somit funktional als Biegeelemente 2 genutzt werden, um eine Parallelverschiebung der Brücke 11 in der z-Richtung oder eine Rotationsbewegung in der xz-Ebene zu ermöglichen. Aus einem anderen Blickwinkel betrachtet kann die Doppel-Vertikalmembran-Anordnung 16 in der x-Richtung komprimiert werden, wobei sich dann die rechte Seite des Glassubstrats 3 entgegen der
x-Richtung auf die linke Seite des Glassubstrats 3 zubewegt.

Die Figur 2 zeigt ein weiteres Ausgestaltungsbeispiel, bei dem eine ähnliche Doppel-Vertikalmembran-Anordnung 16 mittels des LIDE-Verfahrens in einem Glassubstrat 3 nasschemisch definiert wurde, wobei die Anordnung 16 eine Vielzahl an sich jeweils gegenüberliegenden Vertikalmembranen 1 aufweist. Die Vertikalmembranen 1 sind dabei entlang der gezeigten Längsrichtung 31 aufgereiht, wodurch eine monolithische Federstruktur 19 realisiert wird, die reversibel entlang der Längsrichtung 31 (also in x-Richtung in Figur 2) verformbar (komprimierbar und dehnbar) ist. Die Längsrichtung 31 stimmt dabei jeweils mit der Hauptauslenkungsrichtung 6 der jeweiligen Vertikalmembran 1 der Anordnung 16 überein. Die gezeigte monolithische Federstruktur 19 kann aber beispielsweise durch entsprechende Dimensionierung auch so ausgelegt werden, dass die Federstruktur 19 als eine Torsionsfeder verwendet werden kann, wobei dann die Federstruktur 19 um die y-Achse oder die x-Achse verdreht werden kann.

Bei dem Beispiel der Figur 2 ist dabei der erste linke Lochboden 9a durch die Unterseite 18 des Glassubstrats 3 begrenzt, während der letzte rechte Lochboden 9b durch die Oberseite 17 begrenzt ist.

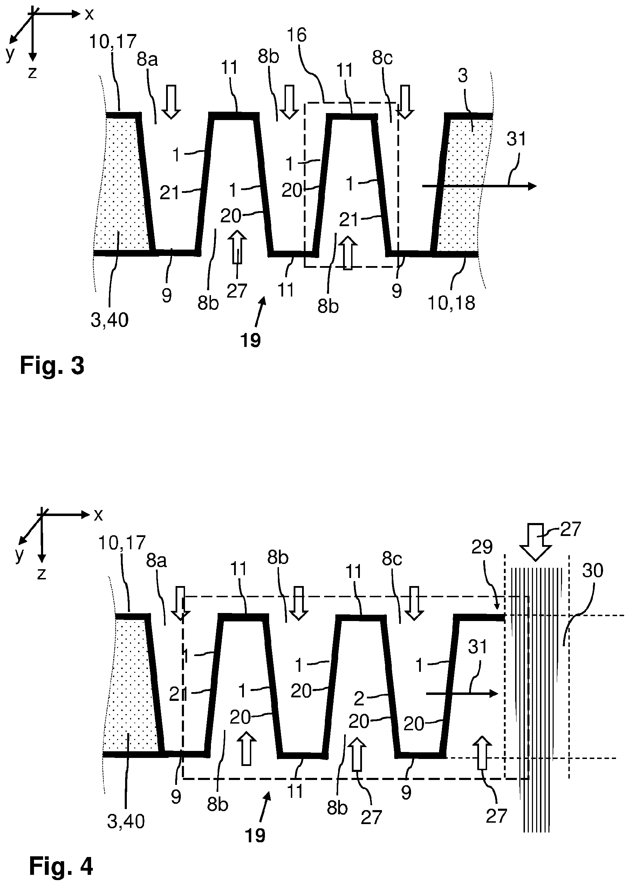

Es sind aber auch Ausgestaltungen möglich, wie etwa in der Figur 3, wo der linke äußere Lochboden 9 und der rechte äußere Lochboden 9 jeweils von der gleichen Außenseite 10 des Glassubstrat 3 begrenzt sind.

In den Beispielen der Figuren 2 und 3 ist somit jeweils die Doppel-Vertikalmembran-Anordnung 16 zu beiden Seiten über einen jeweiligen Lochboden 9 eines jeweiligen äußeren Blindlochs 8 monolithisch mit dem Glassubstrat 3 verbunden. Bei dem Beispiel der Figur 4 wurde hingegen am rechten äußeren Rand der Anordnung 16 ein Laserpuls 27 gesetzt, der in einer vollständigen Durchätzung 30 des Glassubstrats 3 resultiert. Im Ergebnis ist so die Doppel-Vertikalmembran-Anordnung 16 nur einseitig über den ganz linken Lochboden 9 monolithisch mit dem Glassubstrat 3 verbunden und weist somit ein freistehendes Ende 29 auf der rechten Seite auf. Dieses Ende 29 kann sowohl in der Längsrichtung 31, aber auch aus der Substratebene 5 heraus, ausgelenkt werden.

Die jeweils mäandrierende Form der mikromechanischen Federstruktur 19, die in den Beispielen der Figuren 2-4 gezeigt sind, wird dadurch erreicht, dass jeweils wenigstens drei wie in Figur 1 illustrierte Vertikalmembranen 1 aufeinanderfolgen. Bei den gezeigten Beispielen folgen zudem stets mindestens zwei Doppel-Vertikalmembran-Anordnungen 16, wie in Figur 1 exemplarisch gezeigt, aufeinander, wobei jeweils abwechselnd die besagte Brücke 11 an der Oberseite 17 und an der Unterseite 18 angeordnet ist. In diesen Beispielen gibt es also somit jeweils wenigstens eine mittlere Vertikalmembran 20, die links und rechts jeweils mit einer jeweiligen freistehenden Brücke 11 verbunden ist. In Figur 2 erkennt man zum Beispiel gut, dass die auf der linken Seite äußere Vertikalmembran 21 mittels des Lochbodens 9a des äußeren Blindlochs 8a monolithisch verbunden ist, wobei das Blindloch 8a auf der linken Seite, also einseitig, durch den Körper 40 des Glassubstrats 3 begrenzt ist.

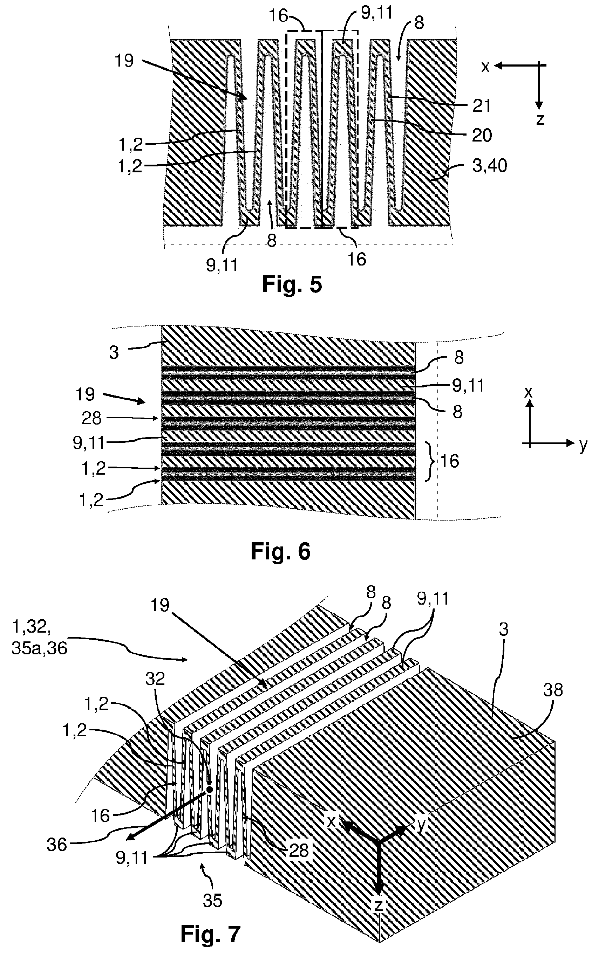

Die Figuren 5-7 illustrieren unterschiedliche Ansichten auf ein weiteres Beispiel einer erfindungsgemäß ausgestalteten mikromechanischen Federstruktur 19, die durch eine Aneinanderreihung von mehreren erfindungsgemäßen Vertikalmembranen 1 monolithisch in dem Glassubstrat 3 ausgestaltet ist. Wie man gerade in der Aufsicht der Figur 6 erkennt, weisen die jeweiligen Vertikalmembranen 1 jeweils links und rechts ein seitliches Ende 28 auf, welches frei beweglich ist.

Würde man den in Figur 7 gezeigten rechten Teil des Glassubstrat 3, der mit dem Bezugszeichen 38 gekennzeichnet ist, in positiver x-Richtung bewegen, so würde die Federstruktur 19 in der x-Richtung gestaucht. Ebenso ist einfach vorstellbar, dass bei Belastung dieses Rotationskörpers 38 in der z-Richtung, der Rotationskörper 38 aus der xy-Ebene 5 herausrotiert werden kann (Rotation um die y-Achse). Damit kann die gezeigte Federstruktur 19 insbesondere als ein monolithisches Festkörpergelenk 35 eingesetzt werden. Hierbei zeigt die in Figur 7 illustrierte Rotationsachse 36, die entlang der y-Achse verläuft, an, dass der Rotationskörper 38 (näherungsweise) mithilfe dieses Festkörpergelenks 35 um die y-Achse rotiert werden kann. Diese Rotationsachse 36 ist dabei quer zur Längsachse 4 der Vertikalmembran 1 (vergleiche Figur 1) als auch quer zu der Flächennormalen 13 des Glassubstrats 3 ausgerichtet. Darüber hinaus ist auch eine etwas geringere Rotation um die z-Achse möglich, wenn nämlich das hintere Ende in x-Richtung etwas stärker gestaucht wird als das vordere Ende der Federstruktur 19. Durch entsprechende Dimensionierung der Vertikalmembrane 1 lassen sich diese Rotationsfreiheitsgrade einstellen.

Die Figuren 8-10 zeigen ein weiteres Beispiel, wie erfindungsgemäße Vertikalmembranen 1 in einem Glassubstrat 3 mithilfe des LIDE-Verfahrens angelegt werden können. Hierbei sind erneut, wie in Figur 1, die mittels eines Lasers modifizierten Bereiche 22 zu erkennen und ebenso, dass die jeweilige Lochtiefe 24 der Blindlöcher 8 etwas tiefer ausfällt als die Tiefe 26 des jeweiligen modifizierten Bereichs 22 aufgrund der durchgeführten Übersetzung, die auch für die nasschemisch erzeugte Verrundung 25 am jeweiligen Lochboden 9 verantwortlich ist. Die Zeichnung ist dabei schematisch zu verstehen und nicht maßstabsgetreu. Anders als noch bei dem Beispiel der Figur 6 zeigt die Figur 9, dass dort die seitlichen Enden 28 der jeweiligen Vertikalmembran 1 nicht freistehend ausgestaltet sind, sondern jeweils mit dem Körper 40 des Glassubstrats 3 monolithisch verbunden sind. Hierbei kann sich aber weiterhin jede der Vertikalmembranen 1 relativ zu dem umgebenden Körper 40 des Glassubstrats 3 verformen, was für vielfältige Anwendungen genutzt werden kann. Beispielsweise sind die in Figur 10 illustrierten Lochböden 9 (vor allem im Zentrum) in der X-Richtung auslenkbar.

Die Figuren 11-14 zeigen weitere Beispiele, wie erfindungsgemäß Vertikalmembranen 1 ausgestaltet sein können. Hierbei zeigt beispielsweise der Vergleich der Figuren 11 und 12, dass die Raumfrequenz der Vertikalmembran 1 in x-Richtung durch Anpassung der x-Breite der jeweiligen Blindlöcher 8 aber auch der Lochböden 9 angepasst werden kann. Ebenso erkennt man, dass durch geeignete Wahl der Lochtiefe 24 des jeweiligen Blindlochs 8 die Ausdehnung der jeweiligen Vertikalmembran 1 in der z-Richtung verändert werden kann. Solche Parameter lassen sich über die Tiefe (Modifikationstiefe 26) und/oder Breite der modifizierten Bereiche 22 als auch über die Ätzzeit steuern (Vgl. dazu die Figuren 11 und 12). Bei beiden Ausgestaltungen der Figuren 11 und 12 liegen die jeweiligen Vertikalmembranen 1, genauer deren geometrische Schwerpunkte 32, dabei im Zentrum des Glassubstrats 3, also auf der illustrierten Mittelebene 33.

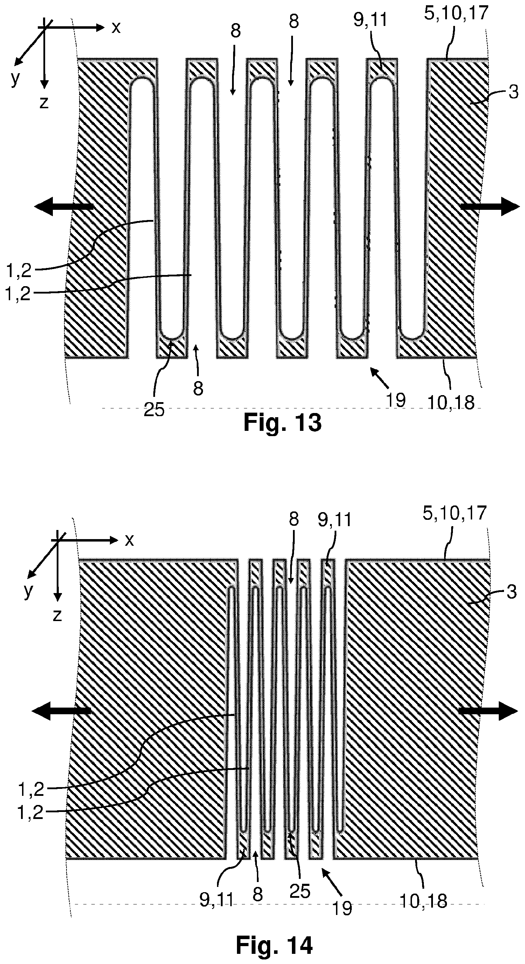

Durch Variation der Anisotropie des zum Freilegen der jeweiligen Vertikalmembran 1 verwendeten nasschemischen Ätzprozesses lässt sich du zudem auch der Taperwinkel 15 einstellen, was beispielsweise am Vergleich der Figuren 13 und 14 gut zu erkennen ist. Auch hier erkennt man wieder deutlich, dass die Federstruktur 19 der Figur 14 eine wesentlich höhere Raumfrequenz in x-Richtung aufweist als die Federstruktur 19 der Figur 13. Ein weiterer Design-Parameter, der variiert werden kann, besteht im Verhältnis der x-Breite des Blindlochs 8 im Vergleich zur x-Breite des zugehörigen Lochbodens 9. Dieses Verhältnis bestimmt im Wesentlichen die Dicke der jeweiligen Vertikalmembran 1 in der x-Richtung.

Die Figur 15 zeigt ein weiteres Beispiel, bei dem mithilfe zweier Vertikalmembranen 1, die mit dem erfindungsgemäßen Verfahren monolithisch in dem Glassubstrat 3 ausgebildet wurden, zwei Festkörpergelenke 35a, 35b in der Tiefe des Glassubstrats 3 definiert wurden, an welchen der gezeigte monolithische Rotationskörper 38 aufgehängt ist. Wird das gezeigte Glassubstrat 3 beispielsweise in der x-Richtung gestreckt, so wird bei der gezeigten Anordnung der Rotationskörper 38 eine Rotation im Uhrzeigersinn um die y-Achse ausführen, wie dies durch den gestrichelten Pfeil illustriert ist. Hierzu sind die beiden Festkörpergelenke 35a und 35b, genauer die beiden geometrischen Schwerpunkte 32 der jeweiligen Vertikalmembran 1, so angeordnet, dass die jeweiligen Rotationsachsen 36 a und 36b (die in dem Beispiel achsparallel jeweils in der y-Richtung verlaufen) durch eine Verbindungslinie 37 verbunden werden können, die einen Winkel einschließt zu der xy-Substratebene 5. Bei der Ausgestaltung der Figur 15 verläuft diese Verbindungslinie 37 auch durch das Zentrum des Glassubstrats 3 bezogen auf die z-Dimension, und zwar im Zentrum des Rotationskörpers 38 bezogen auf die x-Position. Aufgrund der unterschiedlichen Lochtiefe 24 der beiden Blindlöcher 8a und 8b in Figur 15 erkennt man zudem, dass entsprechend auch die x-Breite des jeweiligen Lochbodens 9 variiert.

Die Figur 16 illustriert ein weiteres erfindungsgemäßes Beispiel, bei dem insgesamt vier erfindungsgemäß ausgestalteten Vertikalmembranen 1 verwendet werden (die jeweils mithilfe des LIDE-Verfahrens monolithisch in dem Glassubstrat 3 angelegt wurden), um vier Festkörpergelenke 35a, 35b, 35c und 35d zu realisieren. Diese Festkörpergelenke 35a, 35b, 35c und 35d ermöglichen es, eine Bewegung des Glassubstrats 3 in der Substratebene 5 in eine kontinuierliche Hubbewegung des im Zentrum angeordneten monolithischen Translationskörpers 39 in Richtung der Flächennormalen 13, also in z-Richtung in Figur 16, umzusetzen. Wird beispielsweise das Glassubstrat 3 durch eine Zugbelastung am linken und rechten Ende gestreckt, so kann der gezeigte Translationskörper 39 in Zentrum linear aus der Substratebene 5 in einer Translationsbewegung (in der gezeigten z-Richtung) heraus bewegt werden. Wie zu sehen ist, ist dazu der Translationskörper 39 jeweils über einen jeweiligen Rotationskörper 38a, 38b monolithisch mit dem Glassubstrat 3 verbunden. Hierbei weisen die Rotationskörper 38a und 38b einen gegensinnigen Rotationssinn auf, was durch achsensymmetrische Ausgestaltung der Festkörpergelenke 35 in Bezug auf die gezeigte Mittelachse 14 (angeordnet im Zentrum des Translationskörpers 39) erzielt wird.

Wie der gestrichelte Kreis in den Figuren 16 und 12 illustriert, könnte das jeweilige in Figur 16 gezeigte Festkörpergelenk 35 auch durch Verwendung mehrerer Vertikalmembranen 1, also insbesondere mittels einer wie in Figur 12 gezeigten mikromechanischen Federstruktur 19, ausgestaltet werden.

Die Federstruktur 19 der Figur 18 unterscheidet sich von denjenigen der Figuren 11-14 insbesondere dadurch, dass einzelne der Lochböden 9 nicht durch die Außenseite 10 des Glassubstrat 3 begrenzt sind, sondern durch ein gegenläufiges Blindloch 8. Mit anderen Worten sind bei der Federstruktur 19 der Figur 18 zwei aufeinander folgende Vertikalmembrane 1 durch einen Lochboden 9 verbunden, der oberhalb und unterhalb von einem jeweiligen Blindloch 8 begrenzt ist. Wie man anhand der drei Laserpulse 27 erkennt, die von der Unterseite 18 her eingebracht wurden, wird diese Federstruktur 19 insbesondere dadurch ermöglicht, dass die Vertikalmembrane 1 der gezeigten Doppel-Vertikalmembran-Anordnung 6 mithilfe von Blindlöchern 8 definiert sind, die gleichsinnig verlaufen und ineinander übergehen und dabei unterschiedliche Lochtiefen 24 aufweisen. Bei dem gezeigten Beispiel ist dabei mindestens jeweils eine Kombination von drei gleichsinnig verlaufenden, ineinander übergehenden Blindlöchern von der Unterseite 18 und von der Oberseite 17 her in das Glassubstrat 3 mittels LIDE eingebracht worden.

Die Federstruktur 19 der Figur 19 zeichnet sich in vorteilhafter Weise dadurch aus, dass die jeweiligen Brücken 11 jeweils beabstandet von den Außenseiten 10 des Glassubstrats 3 angeordnet sind, nämlich in der Tiefe des Glassubstrats 3. Dadurch ist die Federstruktur 19 vor mechanischen Einflüssen besser geschützt. Zudem fällt auf, dass die Vertikalmembrane 1 sehr viel stärker geneigt sind zur Flächennormalen 13 / zur z-Achse (der Taperwinkel 15 beträgt in Figur 19 mehr als 10°) als bei den vorherigen Beispielen. Dies wird dadurch erreicht, dass beim Freiätzen der Vertikalmembrane 1 eine sehr viel geringere Anisotropie der nasschemischen Ätzlösung eingestellt ist (wobei hierzu auch das Glasmaterial entsprechend gewählt sein muss), sodass die Ätzung mehr in die Breite geht und der Taperwinkel 15 und damit die Neigung der jeweiligen Vertikalmembran 1 zur z-Achse zunimmt.

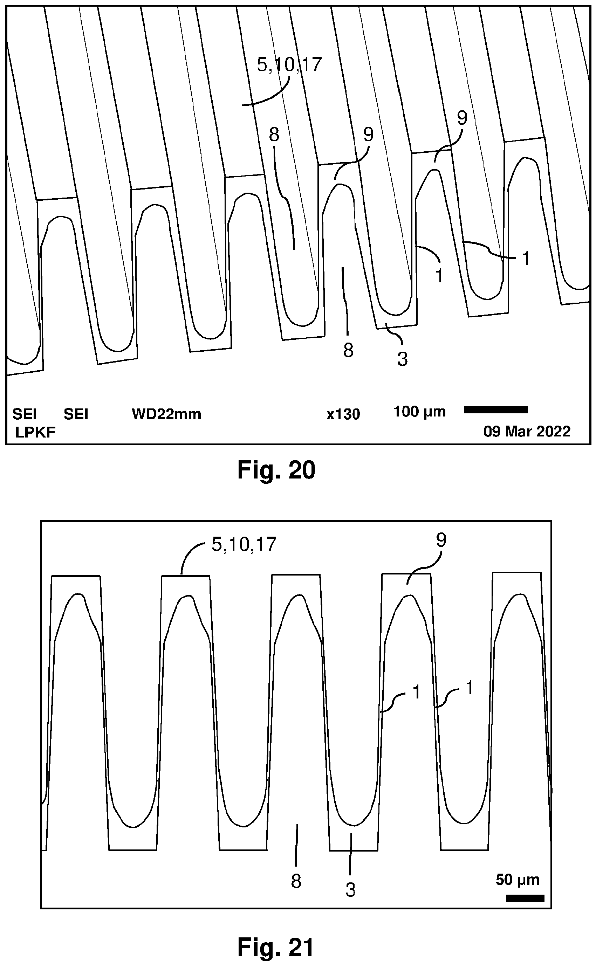

Die Figur 20 schließlich zeigt ein mit einem Rasterelektronenmikroskop aufgezeichnetes Bild einer mikromechanischen Federstruktur 19, die mittels des LIDE-Verfahrens auf Basis einer erfindungsgemäßen Vertikalmembran 1 definiert wurde. Es ist einerseits zu erkennen, dass die Membrane 1 in vertikaler Richtung in Bezug auf die Substratebene 5 verläuft und zudem eine Dicke von wenigen Mikrometern aufweist, während beispielsweise die Lochböden 9 eine Breite von ca. 50 µm aufweisen.

Zusammenfassend wird zur Erweiterung der Anwendungsmöglichkeiten von mikromechanischen Biegestrukturen 2 in Glas vorgeschlagen, quer zu einer Substratebene 5 eines Glassubstrats 3 verlaufende Vertikalmembrane 1 monolithisch in dem Glassubstrat 3 auszubilden, indem Blindlöcher 8 mithilfe einer laserinduzierten Modifikation des Glassubstrat 3 und einer nachfolgenden nasschemischen Ätzung angelegt werden. Hierdurch lassen sich nicht nur Biegestrukturen 2 innerhalb des Körpers 40 des Glassubstrat 3 anordnen, sondern auch Federstrukturen 19 sowie Festkörpergelenke 35. Dies ermöglicht auch neuartige Aktivierungskonzepte in Glas (Vgl. Figur 5).

### Bezugszeichenliste

- 1: Vertikalmembran
- 2: Biegestruktur, insbesondere Federbalken
- 3: Glassubstrat
- 4: Längsachse (von 1)
- 5: Substratebene (ebene Oberfläche von 3)
- 6: Hauptauslenkungsrichtung (von 1)
- 7: Oberfläche (von 1)
- 8: Blindloch
- 9: Lochboden (von 8)
- 10: Außenseite (von 3)
- 11: Brücke
- 12: Lochwand (von 8)
- 13: Flächennormale (von 3)
- 14: Mittelachse
- 15: Taperwinkel
- 16: Doppel-Vertikalmembran-Anordnung
- 17: Oberseite (von 3)
- 18: Unterseite (von 3)
- 19: Federstruktur
- 20: mittlere Vertikalmembran (von 19)
- 21: äußere Vertikalmembran (von 19)
- 22: modifizierter Bereich (von 3 - hier wurde mittels eines Lasers / durch Setzen eines Laserpulses eine Modifikation in 3 induziert, die die nasschemische Ätzrate wesentlich erhöht im Vergleich zu den sonstigen nicht-modifizierten Bereichen von 3)
- 23: nicht-modifizierter Bereich (von 3 - dieser Bereich liegt außerhalb der eingebrachten Laserstrahlung)
- 24: Lochtiefe (von 8 in z-Richtung)
- 25: Verrundung (im Zentrum von 8/9)
- 26: Modifikationstiefe (= Tiefe von 22 in z-Richtung von 3)
- 27: Laserpuls
- 28: seitliches Ende (von 1)
- 29: freistehendes vorderes Ende (von 16 / 19)
- 30: Durchätzung
- 31: Längsrichtung (von 16/19)
- 32: geometrischer Schwerpunkt (von 1)
- 33: Mittelebene (von 3)
- 34: Linearfeder
- 35: Festkörpergelenk
- 36: Rotationsachse (von 35)
- 37: Ätzradius
- 38: Rotationskörper
- 39: Translationskörper
- 40: Körper (engl. bulk) von 3

## Patentansprüche

1. Monolithische Membran (1) aus Glas,
- insbesondere ausgestaltet als
- einseitig oder beidseitig aufgehängte Vertikalmembran (1) und/oder als
- einseitig oder beidseitig aufgehängte mikromechanische Biegestruktur (2), insbesondere als ein einseitig oder beidseitig aufgehängter auslenkbarer Federbalken, wobei
- die Membran (1) aus einem Glassubstrat (3) durch laserinduzierte Modifikation des Glassubstrats (3) und nachfolgende nasschemische Ätzung freigelegt wurde,
- und die Membran (1) als eine Vertikalmembran (1) ausgestaltet ist, sodass eine Ebene der Vertikalmembran (1) quer zu einer Substratebene (5) des Glassubstrats (3) verläuft, **dadurch gekennzeichnet,**
- **dass** wenigstens eine Oberfläche (7) der Vertikalmembran (1) durch ein Blindloch (8) begrenzt ist, welches mittels laserinduzierter Modifikation des Glassubstrats (3) und nachfolgender nasschemischer Ätzung erzeugt wurde.

2. Vertikalmembran (1) nach Anspruch 1,
- wobei die durch das Blindloch (8) begrenzte Oberfläche (7) quer zu einer Hauptauslenkungsrichtung (6) der Vertikalmembran (1) verläuft,
- vorzugsweise wobei das Blindloch (8) einen nicht-kreisrunden Querschnitt aufweist und/oder
- wobei das Blindloch (8) quer zu der Hauptauslenkungsrichtung (6) der Vertikalmembran (1) länger ausgestaltet ist als das Blindloch (8) in Richtung einer Flächennormalen (13) des Glassubstrats (3) tief ist.

3. Vertikalmembran (1) nach Anspruch 1 oder 2,
- wobei die Vertikalmembran (1) durch zwei lateral zueinander versetzte, insbesondere gegenläufige, Blindlöcher (8a, 8b) begrenzt ist,
- insbesondere wobei die beiden Blindlöcher (8a, 8b) eine jeweilige Lochtiefe (24) aufweisen, die weniger als 5% voneinander abweichen und/oder wobei ein geometrischer Schwerpunkt (32) der Vertikalmembran (1) näherungsweise in einer Mittelebene (33) des Glassubstrats (3) angeordnet ist, oder
- wobei die beiden Blindlöcher (8a, 8b) eine jeweilige Lochtiefe (24) aufweisen, die mehr als 20%, insbesondere mehr als 50%, voneinander abweichen und/oder wobei ein geometrischer Schwerpunkt (32) der Vertikalmembran (1) exzentrisch zu einer Mittelebene (33) des Glassubstrats (3) angeordnet ist.

4. Vertikalmembran (1) nach einem der vorhergehenden Ansprüche, wobei zwei sich gegenüberliegende Oberflächen (7a, 7b) der Vertikalmembran (1), vorzugsweise die jeweils achsparallel entlang einer Längsachse (4) der Vertikalmembran (1) und/oder die jeweils in einem gleichen Taperwinkel (15) zu einer Flächennormalen (13) des Glassubstrats (3) verlaufen, durch je ein zugehöriges Blindloch (8) begrenzt sind,
- vorzugsweise wobei die beiden Blindlöcher (8) in gegensinniger Verlaufsrichtung ausgestaltet sind.

5. Vertikalmembran (1) nach einem der vorhergehenden Ansprüche, wobei das Blindloch (8) oder die Blindlöcher (8) jeweils wenigstens eine Lochwand (12a, 12b) aufweisen, die in einem Taperwinkel (15) zu einer Flächennormalen (13) des Glassubstrats (3) verläuft,
- insbesondere wobei der Taperwinkel (15) mehr als 1.0°, insbesondere mehr als 1.5°, beträgt und/oder
- wobei ein Querschnitt des jeweiligen Blindlochs (8) in einer Vertikalebene quer zu einer Substratebene (5) des Glassubstrats (3) in Richtung auf einen jeweiligen zugehörigen Lochboden (9) hin abnimmt und/oder
- wobei ein Lochboden (9) des jeweiligen Blindlochs (8) durch eine Außenseite (10) des Glassubstrats (3), insbesondere durch eine Oberseite (17) oder eine Unterseite (18) des Glassubstrats (3), begrenzt ist.

6. Vertikalmembran (1) nach einem der vorhergehenden Ansprüche, wobei eine Längsachse (4) der Vertikalmembran (1) quer, insbesondere schräg, zu einer Substratebene (5) des Glassubstrats (3) verläuft,
- vorzugsweise wobei die Längsachse (4) in einem Taperwinkel (15) zu einer Flächennormalen (13) des Glassubstrats (3) verläuft,
- insbesondere wobei der Taperwinkel (15) durch eine Anisotropie der nasschemischen Ätzung von modifizierten Bereichen (22) des Glassubstrats (3) definiert ist, die laserinduziert modifiziert wurden und/oder
- wobei jeweilige Lochwände (12a, 12b) der beiden Blindlöcher (8a, 8b) jeweils den Taperwinkel (15) zur Flächennormalen (13) einschließen, insbesondere und somit die beiden Blindlöcher (8a, 8b) mit gleicher Querschnittsform ausgebildet sind.

7. Vertikalmembran (1) nach einem der vorhergehenden Ansprüche, wobei eine Hauptauslenkungsrichtung (6) der Vertikalmembran (1) quer, insbesondere parallel, zur Substratebene (5) verläuft und/oder
- wobei die Vertikalmembran (1) quer, insbesondere parallel, zur Substratebene (5) ihre größte Auslenkbarkeit aufweist und/oder
- wobei wenigstens ein seitliches Ende (28) der Vertikalmembran (1) freistehend angelegt ist,
- insbesondere sodass dieses Ende (28) bei entsprechender mechanischer Anregung eine Schwingung ausführen kann.

8. Doppel-Vertikalmembran-Anordnung (16) mit wenigstens zwei sich gegenüberliegenden Vertikalmembranen (1), die jeweils aus einem Glassubstrat (3) durch laserinduzierte Modifikation des Glassubstrats (3) und nachfolgende nasschemische Ätzung freigelegt wurden, sodass die jeweilige Membran (1) als eine Vertikalmembran (1) ausgestaltet ist und sodass eine jeweilige Ebene der jeweiligen Vertikalmembran (1) quer zu einer Substratebene (5) des Glassubstrats (3) verläuft, **dadurch gekennzeichnet,**
- **dass** die beiden Vertikalmembranen (1) über eine freistehende Brücke (11) miteinander verbunden sind, die monolithisch im Glassubstrat (3) mittels eines, insbesondere mittigen, Blindlochs (8b) definiert ist.

9. Doppel-Vertikalmembran-Anordnung (16) nach dem vorhergehenden Anspruch, wobei das mittige Blindloch (8b) je eine innere Oberfläche (7b, 7c) der jeweiligen der beiden Vertikalmembranen (1) begrenzt,
- insbesondere wobei eine jeweilige äußere Oberfläche (7a, 7d) der beiden Vertikalmembranen (1) durch je ein äußeres Blindloch (8a, 8b) begrenzt ist,
- vorzugsweise wobei das mittige Blindloch (8b) gegensinnig zu den beiden äußeren Blindlöchern (8a, 8c) verläuft und/oder
- wobei wenigstens eines der äußeren Blindlöcher (8a, 8b) einseitig durch einen Körper (40) des Glassubstrats (3) begrenzt ist,
- insbesondere wobei die Doppel-Vertikalmembran-Anordnung (16) eine Vielzahl an sich jeweils gegenüberliegenden Vertikalmembranen (1) aufweist, die entlang einer Längsrichtung (31) aufgereiht sind, vorzugsweise sodass eine monolithische Federstruktur (19) ausgestaltet ist, die reversibel entlang der Längsrichtung (31) verformbar ist.

10. Doppel-Vertikalmembran-Anordnung (16) nach einem der beiden vorhergehenden Ansprüche, wobei die beiden Vertikalmembranen (1) symmetrisch um eine Mittelachse (14) ausgestaltet sind, und/oder
- wobei zwei aufeinander folgende Vertikalmembrane (1) durch einen Lochboden (9) verbunden sind, der oberhalb und unterhalb von einem jeweiligen Blindloch (8) begrenzt ist und/oder
- wobei die Doppel-Vertikalmembran-Anordnung (16) nur einseitig über einen Lochboden (9) eines äußeren Blindlochs (8a, 8c) monolithisch mit dem Glassubstrat (3) verbunden ist und so ein freistehendes Ende (29) ausbildet, welches aus der Substratebene (5) heraus und/oder in Längsrichtung (31) der Doppel-Vertikalmembran-Anordnung (16) auslenkbar ist.

11. **Mäandrierende mikromechanische Federstruktur (19) aus Glas,** wobei die Federstruktur (19)
- wenigstens drei aufeinander folgende Vertikalmembrane (1) gemäß einem der Ansprüche 1 bis 7 und/oder
- wenigstens zwei aufeinander folgende Doppel-Vertikalmembran-Anordnungen (16) gemäß einem der Ansprüche 8 bis 10
aufweist,
- vorzugsweise wobei wenigstens eine mittlere Vertikalmembran (1,20) der Federstruktur (19) links und rechts jeweils mit einer jeweiligen freistehenden Brücke (11) der wenigstens zwei Doppel-Vertikalmembran-Anordnungen (16) monolithisch verbunden ist,
- insbesondere wobei eine rechte und/oder eine linke äußere Vertikalmembran (1, 21) mit einem Lochboden (9) eines äußeren Blindlochs (8a, 8c) monolithisch verbunden ist, welches einseitig durch einen Körper (40) des Glassubstrats (3) begrenzt ist.

12. **Verwendung**
- **einer Vertikalmembran (1) aus Glas,** die aus einem Glassubstrat (3) durch laserinduzierte Modifikation des Glassubstrats (3) und nachfolgende nasschemische Ätzung freigelegt wurde, wobei die Membran (1) als eine Vertikalmembran (1) ausgestaltet ist, sodass eine Ebene der Vertikalmembran (1) quer zu einer Substratebene (5) des Glassubstrats (3) verläuft, wobei die Vertikalmembran (1) nach einem der Ansprüche 1 bis 7 ausgestaltet ist,
oder
- **einer Doppel-Vertikalmembran-Anordnung (16)** gemäß einem der Ansprüche 8 bis 10,
**zur Ausbildung eines monolithischen Festkörpergelenks (35) aus Glas,**
- wobei das Festkörpergelenk (35) eine Rotation erlaubt um eine Rotationsachse (36), die quer zu einer Längsachse (4) der Vertikalmembran (1) und quer zu einer Flächennormalen (13) des Glassubstrats (3) ausgerichtet ist.

13. Verwendung gemäß dem vorhergehenden Anspruch, wobei zwei derartige Festkörpergelenke (35a, 35b) jeweils mittels wenigstens einer Vertikalmembran (1) monolithisch in einem Glassubstrat (3) ausgebildet werden, sodass ein an den beiden Festkörpergelenken (35a, 35b), vorzugsweise monolithisch, aufgehängter Rotationskörper (38) relativ zum Glassubstrat (3) und aus einer Substratebene (5) des Glassubstrats (3) heraus rotiert werden kann, und/oder
- wobei ein Translationskörper (39) jeweils links und rechts mittels je zwei derartiger Festkörpergelenke (35a, 35b und 35c, 35d) an einem Glassubstrat (3) aufgehängt ist oder wird, und wobei eine Bewegung in einer Substratebene (5) des Glassubstrats (3) mittels der vier Festkörpergelenke (35a, 35b und 35c, 35d) in eine gleichmäßige, vorzugsweise rotationsfreie, Hubbewegung des Translationskörpers (39) entlang der Flächennormalen (13) des Glassubstrats (3) umgesetzt wird.

14. **Verfahren zum Herstellen einer monolithischen Vertikalmembran (1) aus einem Glassubstrat (3),** insbesondere einer Vertikalmembran (1) gemäß einem der Ansprüche 1 bis 7, **dadurch gekennzeichnet,**
- **dass** zum Freistellen der Vertikalmembran (1) wenigstens ein Blindloch (8a, 8b, 8c) in dem Glassubstrat (3) durch laserinduzierte Modifikation des Glassubstrats (3) und nachfolgende nasschemische, vorzugsweise hochgradig anisotrope, Ätzung angelegt wird, sodass das wenigstens eine Blindloch (8a, 8b, 8c) einen monolithischen Lochboden (9) ausbildet,
- wobei das wenigstens eine Blindloch (8a, 8b, 8c) eine Oberfläche (7a, 7b, 7c, 7d) der Vertikalmembran (1) definiert, die
- quer zu einer Substratebene (5) des Glassubstrats (3) verläuft und/oder
- quer zu einer Hauptauslenkungsrichtung (6) der Vertikalmembran (1) verläuft und/oder
- eine Längsrichtung (4) der Vertikalmembran (2) vorgibt.

15. Verfahren nach dem vorherigen Anspruch,
- wobei zwei gegenläufige und lateral zueinander versetzte Blindlöcher (8a, 8b) in dem Glassubstrat (3) durch laserinduzierte Modifikation des Glassubstrats (3) und nachfolgende nasschemische Ätzung angelegt werden, um die Vertikalmembran (1) freizustellen, und/oder
- wobei das wenigstens eine Blindloch (8a, 8b, 8c) durch anisotrope nasschemische Ätzung eines zugehörigen modifizierten Bereichs (22) im Glassubstrat (3) angelegt wird, und/oder
- wobei die Vertikalmembran (1) durch die nasschemische Ätzung von beiden Seiten (17, 18) des Glassubstrats (3) her freigelegt wird, und/oder
- wobei zum Definieren der Vertikalmembran (1) wenigstens zwei gegenläufige Blindlöcher (8a, 8b) in dem Glassubstrat (3) durch Belichten des Glassubstrats (3) mit einem Laser von zwei Seiten her, insbesondere mittels eines zweistufigen Belichtungsprozesses, als laserinduzierte Modifikation in dem Glassubstrat (3) angelegt und nachfolgend in einem gemeinsamen nasschemischen Ätzschritt freigeätzt werden.

## Claims

1. **Monolithic membrane (1) made of glass,**
- in particular designed as
- a vertical membrane (1) suspended on one or both sides and/or as
- a micromechanical bending structure (2) suspended on one or both sides, in particular designed as a deflectable spring beam suspended on one or both sides, wherein
- the membrane (1) has been released from a glass substrate (3) by laser-induced modification of the glass substrate (3) and subsequent wet-chemical etching, and
- the membrane (1) is designed as a vertical membrane (1), so that a plane of the vertical membrane (1) extends transversely to a substrate plane (5) of the glass substrate (3),
**characterized in that**
- at least one surface (7) of the vertical membrane (1) is bounded by a blind hole (8) which was produced by means of laser-induced modification of the glass substrate (3) and subsequent wet-chemical etching.

2. Vertical membrane (1) according to claim 1,
- wherein the surface (7) bounded by the blind hole (8) extends transversely to a main deflection direction (6) of the vertical membrane (1),
- preferably wherein the blind hole (8) has a non-circular cross-section and/or
- wherein the blind hole (8) is of longer design transversely to the main deflection direction (6) of the vertical membrane (1) than the blind hole (8) is deep in the direction of a surface normal (13) of the glass substrate (3).

3. Vertical membrane (1) according to claim 1 or 2,
- wherein the vertical membrane (1) is bounded by two blind holes (8a, 8b) which are laterally offset relative to one another, in particular in opposite directions,
- in particular wherein the two blind holes (8a, 8b) have a respective hole depth (24) which deviates from one another by less than 5% and/or wherein a geometric center of gravity (32) of the vertical membrane (1) is arranged approximately in a central plane (33) of the glass substrate (3), or
- wherein the two blind holes (8a, 8b) have a respective hole depth (24) which deviates from one another by more than 20%, in particular more than 50%, and/or wherein a geometric center of gravity (32) of the vertical membrane (1) is arranged eccentrically relative to a central plane (33) of the glass substrate (3).

4. Vertical membrane (1) according to one of the preceding claims, wherein two opposing surfaces (7a, 7b) of the vertical membrane (1), preferably each extending axially parallel along a longitudinal axis (4) of the vertical membrane (1) and/or each extending at the same taper angle (15) to a surface normal (13) of the glass substrate (3), are each bounded by an associated blind hole (8),
- preferably wherein the two blind holes (8) are designed to extend in opposite directions.

5. Vertical membrane (1) according to one of the preceding claims, wherein the blind hole (8) or the blind holes (8) each have at least one hole wall (12a, 12b) which extends at a taper angle (15) to a surface normal (13) of the glass substrate (3),
- in particular wherein the taper angle (15) is more than 1.0°, in particular more than 1.5°, and/or
- wherein a cross-section of the respective blind hole (8) decreases in a vertical plane transverse to a substrate plane (5) of the glass substrate (3) in the direction of a respective associated hole bottom (9) and/or
- wherein a hole bottom (9) of the respective blind hole (8) is bounded by an outer side (10) of the glass substrate (3), in particular by an upper side (17) or an underside (18) of the glass substrate (3).

6. Vertical membrane (1) according to one of the preceding claims, wherein a longitudinal axis (4) of the vertical membrane (1) extends transversely, in particular obliquely, to a substrate plane (5) of the glass substrate (3),
- preferably wherein the longitudinal axis (4) extends at a taper angle (15) to a surface normal (13) of the glass substrate (3),
- in particular wherein the taper angle (15) is defined by an anisotropy of the wet-chemical etching of modified regions (22) of the glass substrate (3) which have been laser-induced modified and/or
- wherein respective hole walls (12a, 12b) of the two blind holes (8a, 8b) each enclose the taper angle (15) to the surface normal (13), in particular and thus the two blind holes (8a, 8b) are formed with the same cross-sectional shape.

7. Vertical membrane (1) according to one of the preceding claims, wherein a main deflection direction (6) of the vertical membrane (1) extends transversely, in particular parallel, to the substrate plane (5) and/or
- wherein the vertical membrane (1) has its greatest deflectability transversely, in particular parallel, to the substrate plane (5) and/or
- wherein at least one lateral end (28) of the vertical membrane (1) is free-standing,
- - in particular so that this end (28) can vibrate when mechanically excited.

8. **Double vertical membrane arrangement (16)** having at least two opposing vertical membranes (1), each of which has been released from a glass substrate (3) by laser-induced modification of the glass substrate (3) and subsequent wet-chemical etching, so that the respective membrane (1) is designed as a vertical membrane (1) and so that a respective plane of the respective vertical membrane (1) extends transversely to a substrate plane (5) of the glass substrate (3),
**characterized in that**
- the two vertical membranes (1) are connected to one another via a free-standing bridge (11) which is defined monolithically in the glass substrate (3) by means of a, in particular central, blind hole (8b).

9. Double vertical membrane arrangement (16) according to the preceding claim, wherein the central blind hole (8b) delimits a respective inner surface (7b, 7c) of each of the two vertical membranes (1),
- - in particular wherein a respective outer surface (7a, 7d) of the two vertical membranes (1) is delimited by a respective outer blind hole (8a, 8b),
- preferably wherein the central blind hole (8b) extends in the opposite direction to the two outer blind holes (8a, 8c) and/or
- wherein at least one of the outer blind holes (8a, 8b) is bounded on one side by a body (40) of the glass substrate (3),
- - in particular wherein the double vertical membrane arrangement (16) comprises a plurality of vertical membranes (1) which are arranged opposite one another and which are lined up along a longitudinal direction (31), preferably so that a monolithic spring structure (19) is formed which is reversibly deformable along the longitudinal direction (31).

10. Double vertical membrane arrangement (16) according to one of the two preceding claims, wherein the two vertical membranes (1) are designed symmetrically about a central axis (14), and/or
- wherein two successive vertical membranes (1) are connected by a hole bottom (9) which is bounded above and below by a respective blind hole (8) and/or
- wherein the double vertical membrane arrangement (16) is monolithically connected to the glass substrate (3) only on one side via a hole bottom (9) of an outer blind hole (8a, 8c) and thus forms a free-standing end (29) which can be deflected out of the substrate plane (5) and/or in the longitudinal direction (31) of the double vertical membrane arrangement (16).

11. **Meandering micromechanical spring structure (19) made of glass,** wherein the spring structure (19) comprises
- at least three successive vertical membranes (1) according to one of claims 1 to 7 and/or
- at least two successive double vertical membrane arrangements (16) according to one of claims 8 to 10,
- preferably wherein at least one central vertical membrane (1, 20) of the spring structure (19) is monolithically connected on the left and right in each case to a respective free-standing bridge (11) of the at least two double vertical membrane arrangements (16),
- in particular wherein a right and/or a left outer vertical membrane (1, 21) is monolithically connected to a hole bottom (9) of an outer blind hole (8a, 8c), which is bounded on one side by a body (40) of the glass substrate (3).

12. **Use of**
- **a vertical membrane (1) made of glass** which has been released from a glass substrate (3) by laser-induced modification of the glass substrate (3) and subsequent wet-chemical etching, wherein the membrane (1) is designed as a vertical membrane (1) so that a plane of the vertical membrane (1) extends transversely to a substrate plane (5) of the glass substrate (3), wherein the vertical membrane (1) is designed according to one of claims 1 to 7,
or
- **a double vertical membrane arrangement (16)** according to one of claims 8 to 10,
**for forming a monolithic solid-state joint (35) made of glass,**
- wherein the solid-state joint (35) permits rotation about an axis of rotation (36) which is oriented transversely to a longitudinal axis (4) of the vertical membrane (1) and transversely to a surface normal (13) of the glass substrate (3).

13. Use according to the preceding claim, wherein two such solid-state joints (35a, 35b) are each formed monolithically in a glass substrate (3) by means of at least one vertical membrane (1), so that a body of revolution (38) suspended on the two solid-state joints (35a, 35b), preferably monolithically, can be rotated relative to the glass substrate (3) and out of a substrate plane (5) of the glass substrate (3), and/or
- wherein a translation body (39) is or will be suspended on the left and right by means of two such solid body joints (35a, 35b and 35c, 35d) each on a glass substrate (3), and wherein a movement in a substrate plane (5) of the glass substrate (3) is converted by means of the four solid-state joints (35a, 35b and 35c, 35d) into a uniform, preferably rotation-free, stroke movement of the translation body (39) along the surface normal (13) of the glass substrate (3).

14. **Method for fabricating a monolithic vertical membrane (1) from a glass substrate (3),** in particular a vertical membrane (1) according to one of claims 1 to 7, **characterized in that**
- at least one blind hole (8a, 8b, 8c) is created in the glass substrate (3) by laser-induced modification of the glass substrate (3) and subsequent wet-chemical, preferably highly anisotropic, etching in order to release the vertical membrane (1), so that the at least one blind hole (8a, 8b, 8c) forms a monolithic hole bottom (9),
- wherein the at least one blind hole (8a, 8b, 8c) defines a surface (7a, 7b, 7c, 7d) of the vertical membrane (1), which
- extends transversely to a substrate plane (5) of the glass substrate (3) and/or
- extends transversely to a main deflection direction (6) of the vertical membrane (1) and/or
- specifies a longitudinal direction (4) of the vertical membrane (2).

15. Method according to the preceding claim,
- wherein two blind holes (8a, 8b) are created in the glass substrate (3) in opposite directions and laterally offset to one another by laser-induced modification of the glass substrate (3) and subsequent wet-chemical etching in order to release the vertical membrane (1), and/or
- wherein the at least one blind hole (8a, 8b, 8c) is created by anisotropic wet-chemical etching of an associated modified region (22) in the glass substrate (3), and/or
- wherein the vertical membrane (1) is exposed from both sides (17, 18) of the glass substrate (3) by the wet-chemical etching, and/or
- wherein, for defining the vertical membrane (1), at least two opposing blind holes (8a, 8b) are created in the glass substrate (3) by exposing the glass substrate (3) with a laser from two sides, in particular by means of a two-stage exposure process, as a laser-induced modification in the glass substrate (3) and subsequently etched free in a common wet-chemical etching step.

## Revendications

1. Membrane monolithique (1) en verre,
- conformée en particulier comme
- une membrane verticale (1) suspendue sur une face ou les deux et/ou comme
- une structure flexible micromécanique (2) suspendue sur une face ou les deux, en particulier comme une barre de ressort déviable suspendue sur une face ou les deux,
- la membrane (1) étant dégagée d'un substrat en verre (3) par modification induite par laser du substrat en verre (3) puis gravure chimique par voie humide,
et
- la membrane (1) étant conformée comme une membrane verticale (1), de sorte qu'un plan de la membrane verticale (1) s' étend transversalement par rapport à un plan de substrat (5) du substrat en verre (3),
**caractérisée en ce qu'**au moins une surface (7) de la membrane verticale (1) est délimitée par un trou borgne (8) qui a été produit par modification induite par laser du substrat en verre (3) puis gravure chimique par voie humide.

2. Membrane verticale (1) selon la revendication 1,
- dans laquelle la surface (7) délimitée par le trou borgne (8) s'étend transversalement par rapport à une direction principale de déviation (6) de la membrane verticale (1),
- le trou borgne (8) présentant de préférence une section non circulaire et/ou
- le trou borgne (8) étant plus long dans le sens transversal par rapport à la direction principale de déviation (6) de la membrane verticale (1) que le trou borgne (8) n'est profond dans le sens d'une perpendiculaire (13) à la surface du substrat en verre (3).

3. Membrane verticale (1) selon la revendication 1 ou 2,
- laquelle membrane verticale (1) est délimitée par deux trous borgnes (8a, 8b) décalés latéralement l'un par rapport à l'autre, en particulier dans des directions opposées,
- les deux trous borgnes (8a, 8b) présentant en particulier une profondeur de trou (24) qui diffère de moins de 5 % et/ou un barycentre géométrique (32) de la membrane verticale (1) étant situé approximativement dans un plan médian (33) du substrat en verre (3), ou
- les deux trous borgnes (8a, 8b) présentant une profondeur de trou (24) qui diffère de plus de 20 %, en particulier de plus de 50 %, et/ou un barycentre géométrique (32) de la membrane verticale (1) est excentré par rapport à un plan médian (33) du substrat en verre (3).

4. Membrane verticale (1) selon l'une des revendications précédentes, dans laquelle deux surfaces (7a, 7b) opposées de la membrane verticale (1), de préférence parallèles le long d'un axe longitudinal (4) de la membrane verticale (1) et/ou formant un même angle de conicité (15) par rapport à une perpendiculaire (13) à la surface du substrat en verre (3), sont délimitées chacune par un trou borgne (8) correspondant, les deux trous borgnes (8) étant de préférence orientés dans des directions opposées.

5. Membrane verticale (1) selon l'une des revendications précédentes, dans laquelle le trou borgne (8) ou les trous borgnes (8) comportent chacun au moins une paroi de trou (12a, 12b) qui forme un angle de conicité (15) par rapport à une perpendiculaire (13) à la surface du substrat en verre (3),
- l'angle de conicité (15) étant en particulier de plus de 1,0°, en particulier plus de 1,5° et/ou
- une section de chaque trou borgne (8) diminuant dans un plan vertical transversal par rapport à un plan de substrat (5) du substrat en verre (3) en direction d'un fond de trou (9) correspondant et/ou
- un fond de trou (9) de chaque trou borgne (8) étant délimité par une face extérieure (10) du substrat en verre (3), en particulier par une face supérieure (17) ou une face inférieure (18) du substrat en verre (3).

6. Membrane verticale (1) selon l'une des revendications précédentes, dans laquelle un axe longitudinal (4) de la membrane verticale (1) s'étend transversalement, en particulier à l'oblique, par rapport à un plan de substrat (5) du substrat en verre (3),
- l'axe longitudinal (4) formant en particulier un angle de conicité (15) par rapport à une perpendiculaire (13) à la surface du substrat en verre (3),
- l'angle de conicité (15) étant en particulier modifié par une anisotropie de la gravure chimique par voie humide de zones modifiées (22) du substrat en verre (3) modifié avec induction par laser et/ou
- des parois de trou (12a, 12b) respectives des deux trous borgnes (8a, 8b) formant l'angle de conicité (15) par rapport à la perpendiculaire (13) à la surface, et les deux trous borgnes (8a, 8b) ayant ainsi en particulier la même forme en section.

7. Membrane verticale (1) selon l'une des revendications précédentes, dans laquelle une direction principale de déviation (6) de la membrane verticale (1) est transversale, en particulier parallèle, par rapport au plan de substrat (5) et/ou
- dans laquelle la capacité de déviation maximale de la membrane verticale (1) se situe transversalement, en particulier parallèlement, par rapport au plan de substrat (5) et/ou
- dans laquelle au moins une extrémité latérale (28) de la membrane verticale (1) est posée sans fixation,
- en particulier de telle manière que cette extrémité (28) puisse osciller sous l'effet d'une excitation mécanique correspondante.

8. Agencement de membrane verticale double (16) avec au moins deux membranes verticales (1) qui se font face, dont chacune a été dégagée d'un substrat en verre (3) par modification induite par laser du substrat en verre (3) puis gravure chimique par voie humide, de telle sorte que chaque membrane (1) est conformée comme une membrane verticale (1) et de telle sorte qu'un plan de la membrane verticale (1) en question s'étend transversalement par rapport à un plan de substrat (5) du substrat en verre (3), **caractérisé en ce que** les deux membranes verticales (1) sont reliées l'une à l'autre par un pont libre (11) qui est défini de façon monolithique dans le substrat en verre (3) au moyen d'un trou borgne (8b),en particulier central.

9. Agencement de membrane verticale double (16) selon la revendication précédente, dans lequel le trou borgne (8b) central délimite une surface intérieure (7b, 7c) de chacune des deux membranes verticales (1),
- une surface extérieure (7a, 7d) respective des deux membranes verticales (1) étant notamment délimitée par un trou borgne (8a, 8b) extérieur respectif,
- le trou borgne (8b) central étant de préférence orienté en sens inverse des deux trous borgnes (8a, 8c) extérieurs et/ou
- au moins un des trous borgnes (8a, 8b) extérieurs étant délimité sur un côté par un corps (40) du substrat en verre (3),
- l'agencement de membrane verticale double (16) comportant en particulier plusieurs membranes verticales (1) qui se font face, alignées dans le sens longitudinal (31), de préférence de façon à former une structure de ressort monolithique (19) qui est capable de déformation réversible dans le sens longitudinal (31).

10. Agencement de membrane verticale double (16) selon les deux revendications précédentes, dans lequel les deux membranes verticales (1) sont symétriques autour d'un axe médian (14) et/ou
- dans lequel deux membranes verticales (1) successives sont reliées par un fond de trou (9) qui est délimité en haut et en bas par un trou borgne (8) correspondant et/ou
- dans lequel l'agencement de membrane verticale double (16) est relié d'un seul côté de façon monolithique au substrat en verre (3) par un fond de trou (9) d'un trou borgne (8a, 8c) extérieur et forme ainsi une extrémité libre (29) qui peut être déviée hors du plan de substrat (5) et/ou dans le sens longitudinal (31) de l'agencement de membrane verticale double (16).

11. Structure de ressort micromécanique à méandres (19) en verre, laquelle structure de ressort (19) comporte
- au moins trois membranes verticales (1) selon l'une des revendications 1 à 7 à la suite les unes des autres et/ou
- au moins deux agencements de membrane verticale double (16) selon l'une des revendications 8 à 10 à la suite l'un de l'autre,
- au moins une membrane verticale médiane (1, 20) de la structure de ressort (19) étant reliée de façon monolithique sur la droite et la gauche par un pont libre (11) respectif aux au moins deux agencements de membrane verticale double (16),
- une membrane verticale extérieure (1, 21) de droite et/ou une autre de gauche étant en particulier reliées de façon monolithique avec un fond de trou (9) d'un trou borgne (8a, 8c) extérieur qui est délimité d'un côté par un corps (40) du substrat en verre (3).

12. Utilisation
- d'une membrane verticale (1) en verre dégagée d'un substrat en verre (3) par modification induite par laser du substrat en verre (3) puis gravure chimique par voie humide, la membrane (1) étant conformée comme une membrane verticale (1), de sorte qu'un plan de la membrane verticale (1) s' étend transversalement par rapport à un plan de substrat (5) du substrat en verre (3), la membrane verticale (1) étant conformée selon l'une des revendications 1 à 7,
ou
- d'un agencement de membrane verticale double (16) selon l'une des revendications 8 à 10
pour former une articulation à pivot flexible monolithique (35) en verre,
- laquelle articulation à pivot flexible (35) autorise une rotation autour d'un axe de rotation (36) orienté transversalement par rapport à un axe longitudinal (4) de la membrane verticale (1) et transversalement par rapport à une perpendiculaire (13) à la surface du substrat en verre (3).

13. Utilisation selon la revendication précédente, dans laquelle deux articulations à pivot flexible (35a, 35b) de ce type sont formées chacune de façon monolithique dans un substrat en verre (3) au moyen d'au moins une membrane verticale (1), de sorte qu'un solide capable de rotation (38) suspendu aux deux articulations à pivot flexible (35a, 35b), de préférence de façon monolithique, peut tourner par rapport au substrat en verre (3) et hors d'un plan de substrat (5) du substrat en verre (3), et/ou
- dans laquelle un solide capable de translation (39) peut être suspendu à gauche et à droite sur un substrat en verre (3) avec deux articulations à pivot flexible (35a, 35b et 35c, 35d) de chaque côté, et un mouvement dans un plan de substrat (5) du substrat en verre (3) est réalisé au moyen des quatre articulations à pivot flexible (35a, 35b et 35c, 35d) dans un mouvement de course uniforme, de préférence sans rotation, du solide capable de translation (39) le long de la perpendiculaire (13) à la surface du substrat en verre (3).

14. Procédé pour la fabrication d'une membrane verticale monolithique (1) à partir d'un substrat en verre (3), en particulier d'une membrane verticale (1) selon l'une des revendications 1 à 7, **caractérisé en ce que**
- pour dégager la membrane verticale (1), au moins un trou borgne (8a, 8b, 8c) est créé dans le substrat en verre (3) par modification induite par laser du substrat en verre (3) puis gravure chimique par voie humide, de préférence fortement anisotrope, de sorte que l'au moins un trou borgne (8a, 8b, 8c) forme un fond de trou (9) monolithique,
- l'au moins un trou borgne (8a, 8b, 8c) définissant une surface (7a, 7b, 7c, 7d) de la membrane verticale (1) qui
- s'étend transversalement par rapport à un plan de substrat (5) du substrat en verre (3) et/ou
- s'étend transversalement par rapport à une direction principale de déviation (6) de la membrane verticale (1) et/ou
- définit un sens longitudinal (4) de la membrane verticale (2).

15. Procédé selon la revendication principale
- dans lequel deux trous borgnes (8a, 8b) sont créés dans des directions opposées et décalés l'un par rapport à l'autre dans le substrat en verre (3) par modification induite par laser du substrat en verre (3) puis gravure chimique par voie humide pour dégager la membrane verticale (1) et/ou
- dans lequel l'au moins un trou borgne (8a, 8b, 8c) est créé par gravure chimique par voie humide anisotrope d'une zone modifiée (22) correspondante du substrat en verre (3) et/ou
- dans lequel la membrane verticale (1) est dégagée par gravure chimique par voie humide du substrat en verre (3) par les deux faces (17, 18) et/ou
- dans lequel, pour définir la membrane verticale (1), au moins deux trous borgnes (8a, 8b) sont créés dans le substrat en verre (3) dans des directions opposées par exposition du substrat en verre (3) à un laser par les deux faces, en particulier au moyen d'un procédé d'insolation en deux temps, pour former la modification induite par laser dans le substrat en verre (3), puis sont gravés et dégagés ensemble au cours d'une même étape de gravure chimique par voie humide.
